(19) Europäisches Patentamt
European Patent Office
Office européen des brevets

(11) EP 1 578 175 B1

(12) **EUROPEAN PATENT SPECIFICATION**

(45) Date of publication and mention of the grant of the patent:
**11.05.2011 Bulletin 2011/19**

(21) Application number: **03774011.5**

(22) Date of filing: **13.11.2003**

(51) Int Cl.:
***H05B 33/22*** *(2006.01)* ***H05B 33/14*** *(2006.01)*

(86) International application number:
**PCT/JP2003/014426**

(87) International publication number:
**WO 2004/047500 (03.06.2004 Gazette 2004/23)**

(54) **ORGANIC ELECTROLUMINESCENCE ELEMENT**

ORGANISCHES ELEKTROLUMINESZENZELEMENT

ELEMENT ELECTROLUMINESCENT ORGANIQUE

(84) Designated Contracting States:
**AT BE BG CH CY CZ DE DK EE ES FI FR GB GR HU IE IT LI LU MC NL PT RO SE SI SK TR**

(30) Priority: **18.11.2002 JP 2002333865**

(43) Date of publication of application:
**21.09.2005 Bulletin 2005/38**

(73) Proprietor: **IDEMITSU KOSAN CO., LTD.**
**Tokyo 100-8321 (JP)**

(72) Inventors:
- **FUNAHASHI, Masakazu**
**Sodegaura-shi, Chiba 299-0293 (JP)**
- **FUKUOKA, Kenichi**
**Sodegaura-shi, Chiba 299-0293 (JP)**
- **HOSOKAWA, Chishio**
**Sodegaura-shi, Chiba 299-0293 (JP)**

(74) Representative: **Gille Hrabal Struck Neidlein Prop Roos**
**Patentanwälte**
**Brucknerstrasse 20**
**40593 Düsseldorf (DE)**

(56) References cited:
**EP-A- 1 162 674**
**WO-A-99/48160**
**WO-A-99/53724**
**WO-A-02/074015**
**WO-A1-02/102118**
**WO-A1-02/104080**
**WO-A2-02/074015**
**JP-A- 2000 106 277**
**JP-A- 2000 164 362**
**JP-A- 2002 038 140**
**JP-A- 2002 117 980**
**JP-A- 2002 507 825**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 578 175 B1

## Description

Technical Field

The present invention relates to an organic electroluminescence element.

Background Art

About organic electroluminescence elements (referred to as organic EL elements hereinafter) using an organic substance, the use thereof as inexpensive, large-area, full color display devices of a solid light emission type, has been promising, and many developments thereof have been made.

An organic EL element is composed of a light emitting layer and a pair of opposite electrodes. Fig. 3 is a sectional view of an ordinary organic EL element.

This organic EL element 10 has a light emitting layer 14 sandwiched between a pair of electrodes, an anode 12 and a cathode 13. The light emitting layer 14 is usually composed of plural laminated layers. When an electric field is applied across the electrodes 12 and 13 in this element 10, electrons are injected from the cathode 13 and holes are injected from the anode 12. The electrons and the holes are recombined in the light emitting layer 14 so as to cause an exciting state. When the exciting state returns to a ground state, energy is emitted as light.

Fig. 4 shows an energy diagram of the organic EL element in Fig. 3. In Fig. 3, a valence electron level EV0 (HOMO) and a conduction level EC0 (LUMO), which are energy levels of the light emitting layer 14, are shown. Holes go in from the anode 12 and electrons go in from the cathode 13. The holes and the electrons are combined with each other in the light emitting layer 14 to emit light.

Recently, the practical use of organic EL element displays has been started, and it has been desired to make the luminance and the efficiency thereof higher and make the durability longer.

There is known a technique of adding a very small amount of a fluorescent molecule (dopant) to a light emitting layer in order to satisfy the above-mentioned desire. As the fluorescent molecule, a coumarin, cyanine, perylene or pyran derivative is disclosed (see, for example, Japanese Patent Application Laid-Open No. 63-264692).

Fig. 5 illustrates an energy diagram of an organic EL element to which a dopant is added. In this figure, EC0 represents the conduction level of the host; EV0, the valence electron level of the host; EC1, the conduction level of the dopant; and EV1, the valence electron level of the dopant. Eg0 and Eg1 represent the energy gap (difference between the EC0 and the EV0) of the host and the energy gap (difference between the EC1 and the EV1) of the dopant, respectively.

The dopant receives the energy of the excited host effectively to make the luminescent efficiency high. It is however necessary that the energy gap Eg1 of the dopant is smaller than the energy gap Eg0 of the host in order for the dopant to emit light.

About an improvement in the efficiency of organic EL element displays, an efficiency of about 6 to 7 cd/A is attained. In order to make the efficiency thereof higher and make the durability thereof long, investigations on the addition of various dopants have been made.

For example, a technique of adding distyrylarylene which contains arylamine to a light emitting layer is disclosed (see, for example, WO 94/6157). This technique makes it possible to realize a blue light emitting element having a long durability and give an efficiency of more than 8 cd/A.

Disclosed is also a technique of mixing a diamine type hole transporting material with an electron transporting property, and adding, to this mixture layer, a fluorescent material such as rubrene (see, for example, Japanese Patent Application Laid-Open No. 8-048656). This technique enables a half life of approximately several thousands hours at an initial luminance of several hundreds nit.

Such techniques of adding a dopant to a light emitting layer are very important for improving the luminescent efficiency and emission lifetime of organic EL elements. Thus, various improvements are applied thereto.

However, an organic EL element having a sufficient efficiency and durability has not been developed.

For example, the use of a dopant for carrier transportation or excitation energy shift in a light emitting layer is disclosed. In particular, the following light emitting layers are disclosed: a light emitting layer using Alq, which is an organic metal complex, as a host material, a fluorescent dye such as DCM1, DCM2 or Nile Red as a luminescent dopant, DPA, OXD8 or the like as a dopant for carrier transportation, and/or rubrene or the like as a dopant for excitation energy shift (see, for example, Japanese Patent Application Laid-Open No. 2000-164362 (Examples 7 to 16)).

In this technique, however, the light emitting layer captures both kinds of charges of holes and electrons by using a single luminescent dopant; therefore, the luminescent wavelength therefrom is inconveniently long. In other words, when materials are selected respectively in order to make the injection efficiency of charges from electrodes good, the energy gap between the valence electron level of the selected hole transporting material and the conductive level of the selected electron transporting material becomes about 2.5 eV or less, so as to cause a problem that light having a longer wavelength than yellowish green wavelengths is emitted.

In order to make the durability of an organic EL element longer, a luminescent dopant having an electron trapping property is added thereto. When the addition concentration thereof is increased to sufficiently obtain the advantageous effect of the dopant, the electron trapping property becomes stronger so as to cause a problem that the driving voltage of the organic EL element becomes high.
Further, when the addition concentration becomes larger, the molecules of the dopant contact each other, thereby causing concentration quenching to result in a problem that the efficiency of the organic EL element becomes low.
A carrier transporting dopant, which is a dopant other than the luminescent dopant and is added to the light emitting layer, does not undergo energy shift from the host material; therefore, the carrier transporting dopant gives an effect only for decreasing the driving voltage of the organic EL element.
As another example, there is disclosed an organic electroluminescence layer wherein a host material contains a first dopant which can receive electron-hole bonding energy and a second dopant which can capture holes (see, for example, Japanese Patent Application Laid-Open No. 2002-38140).
In the examples thereof, the luminescent efficiency and the emission lifetime are improved like the above-mentioned examples than examples wherein a single kind of dopant is used. However, in the case of the structure wherein two kinds of dopants can each emit light, each of the dopants captures electrons so that the driving voltage is essentially high, this high driving voltage being improved by the use of a carrier transporting dopant.
As still another example, there is disclosed an organic EL element wherein a first dopant of a diamine derivative and a second dopant of rubrene are incorporated into a host material in a light emitting layer (see, for example, Japanese Patent Application Laid-Open No. 2002-117980).
However, in this element structure also, the diamine derivative, which is the first dopant, has a shorter fluorescent peak wavelength, that is, a larger energy gap than the host material. Thus, the mobility of carriers is improved, thereby making the driving voltage low. However, the effect of improving the emission lifetime is small.
Fig. 6 shows an energy diagram of an organic EL element wherein two kinds of dopants are added, disclosed in Japanese Patent Application Laid-Open No. 2002-117980.
In this figure, description of the same symbols as in Fig. 5 is omitted. EC2 represents the conduction level of the second dopant; EV2, the valence electron level of the second dopant; and Eg2, the energy gap (the difference between EC2 and EV2) of the second dopant.
In this organic EL element, the energy gap Eg2 of the second dopant, which is one of the dopants, is larger than the energy gap Eg0 of the host. Therefore, this dopant does not emit light.
It has been generally considered that in order for a dopant to emit light, like the energy gap Eg1, the energy gap of the dopant needs to be smaller than the energy gap of the host and the conduction level of the dopant needs to be higher than the conduction level of the host. In short, it has been considered that when EC2 is lower than EC0, like the second dopant, light is not emitted.
In light of the above-mentioned problems, an object of the present invention is to provide an organic electroluminescence element having a high luminance, a high efficiency and a long durability.

Disclosure of the Invention

The inventors have made various researches about dopants, and found out that light can be emitted even if the conduction level of a dopant is lower than the conduction level of a host. Furthermore, the inventors have found out that on the basis of this fact, the durability of an organic EL element is improved when energy gaps of a host and a dopant therein satisfy a specific relation, and then made the present invention.
The present invention provides the following elements.

[1] An organic electroluminescence element comprising:

a pair of electrodes, and
a light emitting layer provided between the pair of electrodes, the layer comprising a light-emitting-layer material, a first dopant and a second dopant that satisfy the following relations,

$$(A)\ EV0 > EV1 \text{ and } EV0 > EV2$$

$$(B)\ EC0 \geq EC2$$

$$(C)\ EG0 > EG1 \text{ and } EG0 > EG2$$

wherein EV0, EV1 and EV2 are the valence electron levels of the light-emitting-layer material, the first dopant and the second dopant, respectively; EC0 and EC2 are the conduction levels of the light-emitting-layer material and the second dopant, respectively; and EG0, EG1 and EG2 are the energy gaps of the light-emitting-layer material, the first dopant and the second dopant, respectively;
said valence electron level corresponding to the HOMO and said conduction level corresponding to the LUMO.

[2] The organic electroluminescence element according to [1], comprising the light-emitting-layer material, the first dopant and the second dopant satisfying the following relation,

$$EC0 \geq EC1$$

wherein EC0 and EC1 are the conduction levels of the light-emitting-layer material and the first dopant, respectively.
[3] The organic electroluminescence element according to [1] or [2], wherein both the first dopant and the second dopant emit light.
[4] The organic electroluminescence element according to [1] or [2], wherein the content of the first dopant and/or the second dopant is 20 wt% or less of the entire light-emitting-layer.
[5] The organic electroluminescence element according to [1] or [2], wherein the first dopant has a hole-injection-aiding property, and/or the second dopant has an electron-injection-aiding property.
[6] The organic electroluminescence element according to [1] or [2], wherein the difference between the valence electron level EV0 of the light-emitting-layer material and the valence electron level EV1 of the first dopant is 0.4 eV or less and/or the difference between the conduction level EC0 of the light-emitting-layer material and the conduction level EC2 of the second dopant is 0.4 eV or less.
[7] The organic electroluminescence element according to [1] or [2], wherein the molecular weight of at least one of the light-emitting-layer material, the first dopant and the second dopant is from 100 to 1,500.
[8] The organic electroluminescence element according to [1] or [2], wherein the glass-transition temperature of the light-emitting-layer material is 100°C or more.
[9] The organic electroluminescence element according to [1] or [2], wherein the first dopant or the second dopant is selected from styrylamine derivatives, condensed aromatic ring compounds and arylamine-substitued condensed aromatic ring compounds.
[10] The organic electroluminescence element according to [1] or [2], wherein the light-emitting-layer material comprises a compound having a hole transporting property and/or a compound having an electron transporting property.
[11] The organic electroluminescence element according to [1] or [2], wherein the light-emitting-layer material is selected from phenylanthracene derivatives, naphthylanthracene derivatives, diphenylanthracene derivatives, aromatic amine derivatives and metal complexes.
[12] The organic electroluminescence element according to [11], wherein the phenylanthracene derivatives, the naphthylanthracene derivatives or the diphenylanthracene derivatives contain an alkenyl group.
[13] The organic electroluminescence element according to [1]or [2], further comprising a hole injecting layer between the anode and the light emitting layer; the hole injecting layer comprising a compound having a phenylenediamine structure.

Brief Description of the Drawings

Fig. 1 is the energy diagram of a light emitting layer of an organic EL element of a first embodiment of the invention.
Fig. 2 is the energy diagram of a light emitting layer of an organic EL element of a second embodiment of the invention.
Fig. 3 is a sectional view of an ordinary organic EL element.
Fig. 4 is the energy diagram of an organic EL element.
Fig. 5 is the energy diagram of an organic EL element to which a dopant is added.
Fig. 6 is the energy diagram of an organic EL element to which two kinds of dopants are added.

Best Modes for Carrying Out the Invention

An organic EL element of a first embodiment of the present invention has a light emitting layer formed between a pair of electrodes, the light emitting layer comprising a light-emitting-layer material, and a first dopant and a second dopant that satisfy the following relations:

$$(A)\ EV0 > EV1 \text{ and } EV0 > EV2$$

$$(B)\ EC0 \geq EC2$$

$$(C)\ Eg0 > Eg1 \text{ and } Eg0 > Eg2$$

wherein EV0, EV1 and EV2 are the valence electron levels of the light-emitting-layer material, the first dopant and the second dopant, respectively; EC0 and EC2 are the conduction levels of the light-emitting-layer material and the second dopant, respectively; and EG0, EG1 and EG2 are the energy gaps of the light-emitting-layer material, the first dopant and the second dopant, respectively.

Fig. 1 is the energy diagram of this organic EL element.

In the energy diagram, the level of vacuum (not illustrated) is used as a standard, and the following are shown: the valence electron level EV0 and the conduction level EC0 of the light-emitting-layer material; the valence electron level EV1 and the conduction level EC1 of the first dopant; and the valence electron level EV2 and the conduction level EC2 of the second dopant. Shown are also the energy gap Eg0 of the light-emitting-layer material, the energy gap Eg1 of the first dopant, and the energy gap Eg2 of the second dopant. The energy gaps are each the difference in energy between the valence electron level of each of the materials and the conduction level thereof.

In this figure, an arrow represents the direction along which the energy level becomes higher.

The valance electron levels are a value measured by use of a photoelectron spectrometer (AC-1, manufactured by Riken Keiki Co., Ltd.) in the atmosphere. The energy gaps are a value measured from an absorption edge of the absorption spectrum in benzene. The conduction levels are a value calculated from measured values of the valence electron level and the energy gap.

As shown in Fig. 1, in this light emitting layer, the valence electron level EV0 of the light-emitting-layer material is higher than the valence electron level EV1 of the first dopant and the valence electron level EV2 of the second dopant. That is to say, the relation of EV0 > EV1 and EV0 > EV2 is satisfied. Such a structure enables the first and second dopants to easily capture holes injected into the host material to emit light. Preferably, the energy level difference 5 between EV0 and EV1 is 0.4 eV or less.

The conduction level EC0 of the light-emitting-layer material is not less than the conduction level EC2 of the second dopant. That is, the relation of EC0 ≥ EC2 is satisfied. The purpose of this is to cause the second dopant not to capture electron injected into the light-emitting-layer material. In this way, the function of capturing holes is strengthened, so that luminescence having a long durability can be attained at a low voltage.

The energy level difference 6 between EC0 and EC2 is preferably 0.4 eV or less.

The energy gap Eg0 of the light-emitting-layer material is larger than the energy gap Eg1 of the first dopant and the energy gap Eg2 of the second dopant. That is, the relation of Eg0 > Eg1, Eg2 is satisfied.

The light-emitting-layer material is deteriorated by the repetition of excitation and inactivation. In the present invention, however, both of the first and second dopants can receive energy shift from the excitation state of the light-emitting-layer material; therefore, the invention makes it possible to suppress the deterioration of the light-emitting-layer material as compared with the case that either one of the dopants can receive energy shift from the excitation state of the light-emitting-layer material. Accordingly, the luminescent efficiency of the element can be improved and the durability thereof can be made long.

In an organic EL element of a preferred embodiment of the present invention, the light-emitting-layer material, and the first dopant satisfy the following relation:

$$EC0 \geq EC1$$

wherein EC0, and EC1 are the conduction levels of the light-emitting-layer material, and the first dopant respectively.

Fig. 2 is the energy diagram of this organic EL element.

Symbols shown in Fig. 2 have the same meanings as the symbols shown in Fig. 1.

As shown in Fig. 2, in this light emitting layer, the conduction level EC0 of the light-emitting-layer material is not less than the conduction level EC1 of the first dopant and the conduction level EC2 of the second dopant. That is, the relation of EC0 ≥ EC1, EC2 is satisfied. The purpose of this is to cause each of the dopants not to capture electrons. The element having such a structure can be driven at a low voltage.

A dopant needs to be added up to a concentration that the dopant can sufficiently capture holes injected into the light-emitting-layer material. In the case that two kinds of dopants having the above-mentioned relations are added, the concentration of the each of the dopants is relatively smaller than in the case that only one kind of dopant is added. It is therefore possible to restrain concentration quenching based on contact between the dopants. For this reason, the durability of the organic EL element can be made long.

This is particularly remarkable in the case of blue light emitting elements. The above-mentioned structure is a particularly preferable for element structures having a large energy gap.

In the organic EL element of the invention, a light-emitting-layer material (host material) and dopants that are used in conventional organic EL elements can be used if the light-emitting-layer material and the first and second dopants are selected to satisfy the above-mentioned relations.

Examples of the light-emitting-layer material include phenylanthracene, naphthylanthracene, diphenylanthracene derivatives, aromatic amine derivatives, metal complexes, polyphenyl derivatives, carbazole derivatives, and styrylarylene derivatives. The material is preferably selected from phenylanthracene, naphthylanthracene, diphenylanthracene derivatives, aromatic amine derivatives, and metal complexes. It is particularly preferred that phenylanthracene, naphthylanthracene, or diphenylanthracene derivatives contain an alkenyl group.

The glass transition temperature of the light-emitting-layer material is preferably 100°C or higher in order to maintain the thermal stability of the organic EL element. The temperature is in particular preferably 120°C or higher.

Specific compound examples of the light-emitting-layer material are illustrated below.

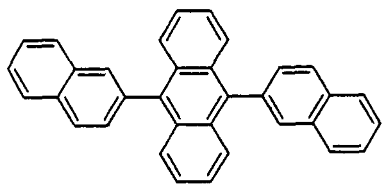

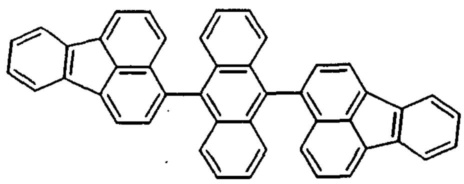

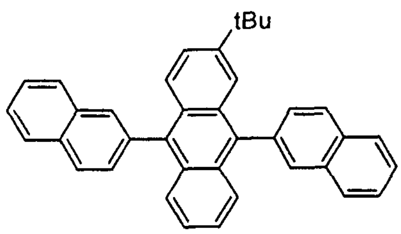

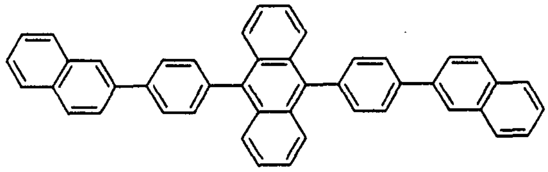

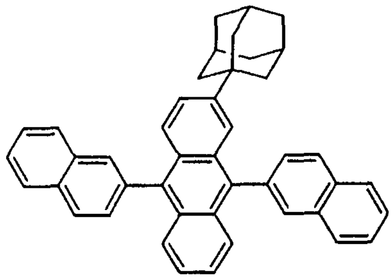

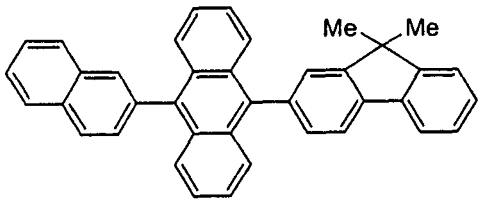

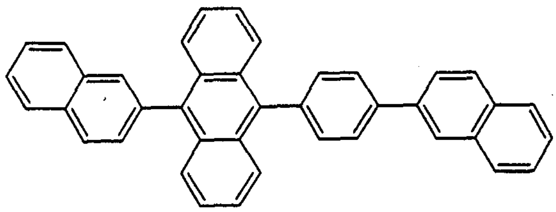

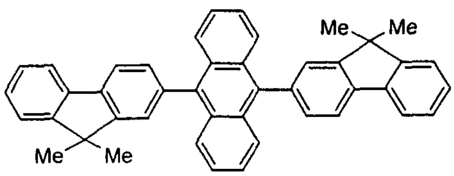

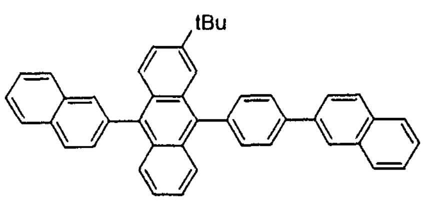

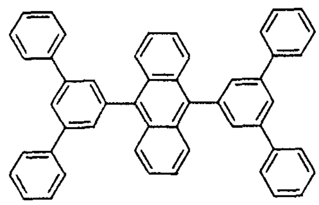

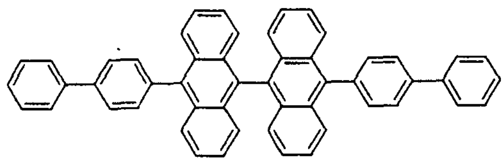

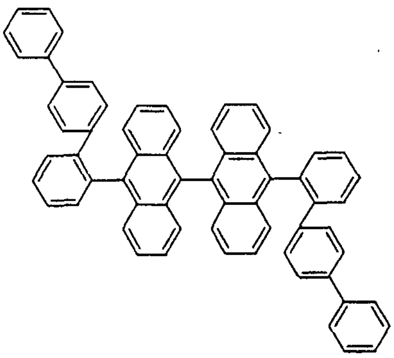

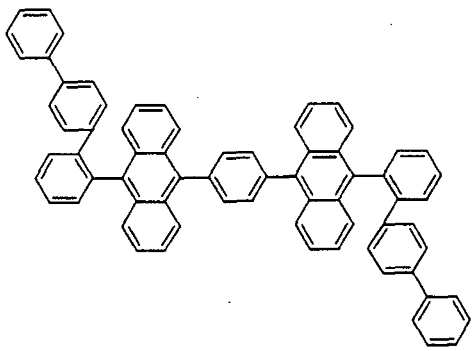

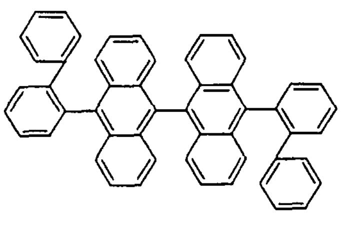

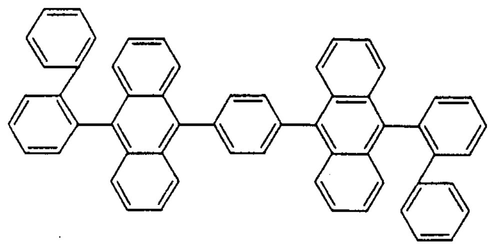

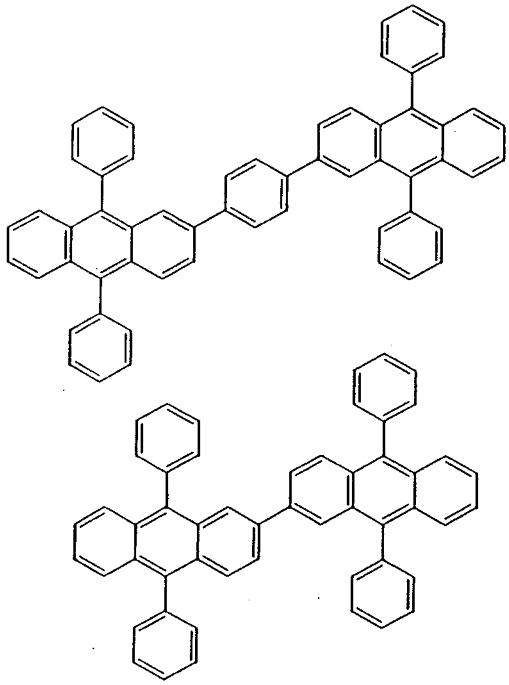

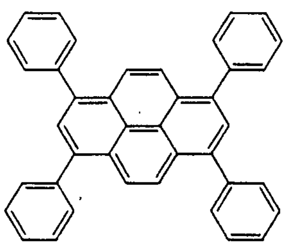

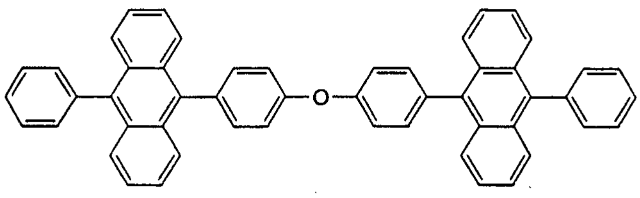

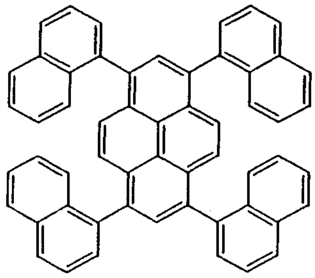

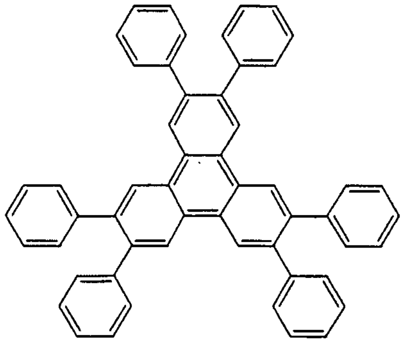

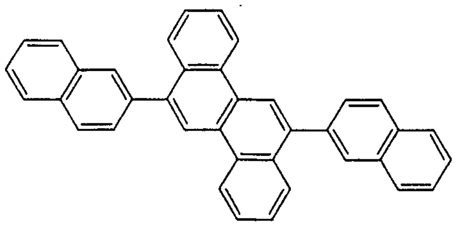

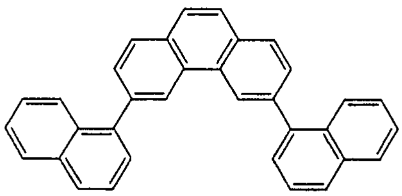

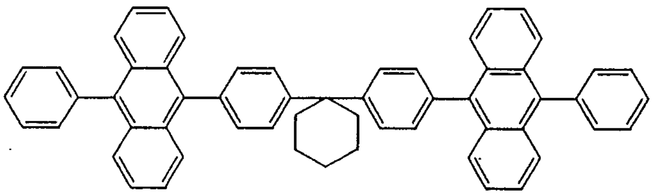

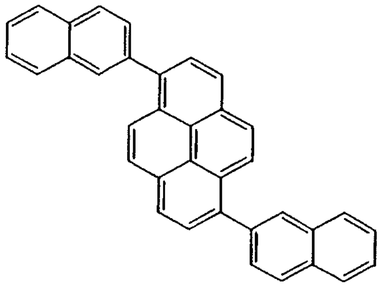

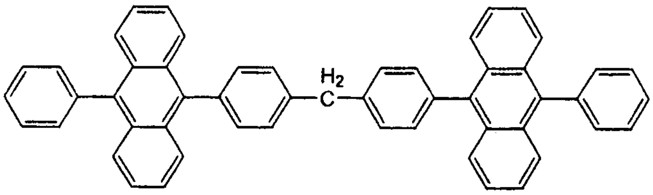

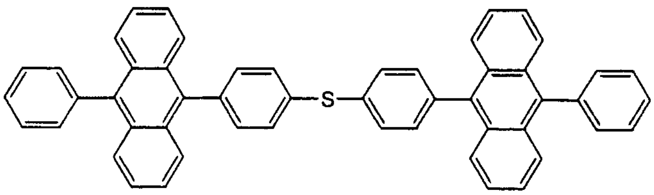

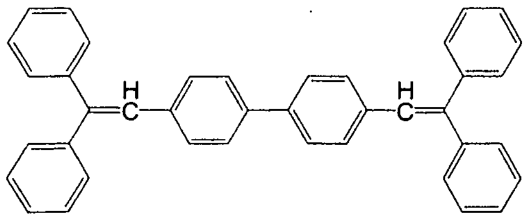

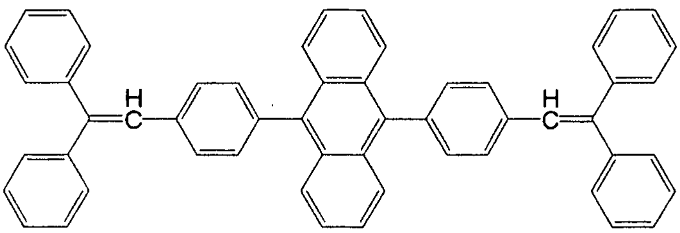

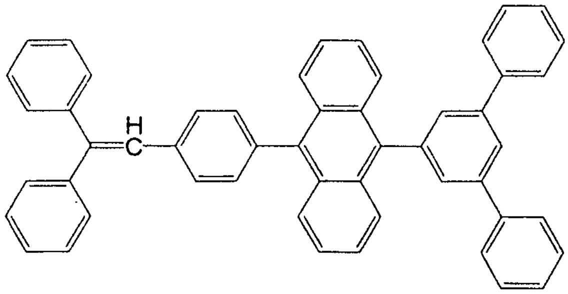

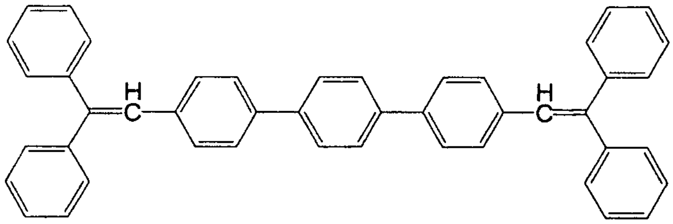

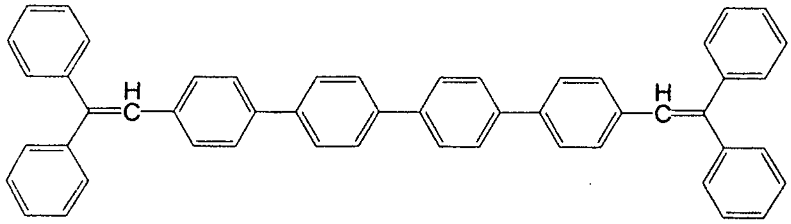

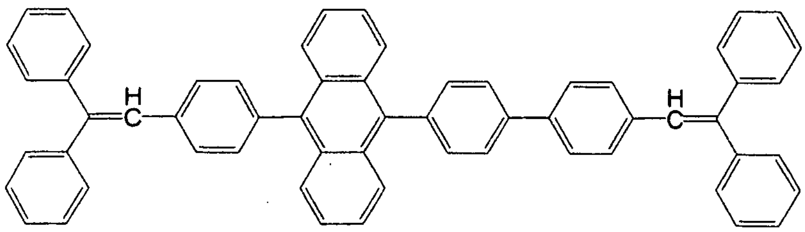

The light-emitting-layer material preferably contains a hole transmitting compound and/or an electron transmitting compound.

The hole transmitting compound is a compound having a property of transporting holes when an electric field is applied thereto. Examples thereof include polyphenyl derivatives, aromatic amines, and styrylarylene derivatives.

The electron transmitting compound is a compound having a property of transporting electrons when an electric field is applied thereto. Examples thereof include metal complexes such as an 8-hydroxyquinolinol aluminum complex.

The light-emitting-layer material is preferably composed of an electron transmitting first light-emitting-layer material and a hole transmitting second light-emitting-layer material. This makes it possible that two different compounds play a part for transporting holes and a part for transporting electrons, respectively, to transport the holes and the electrons stably into a recombining zone.

Examples of the first dopant and the second dopant include arylamine derivatives, styrylamine derivatives, condensed aromatic ring compounds, and arylamine-substituted condensed aromatic ring compounds. They are preferably selected from arylamine derivatives, styrylamine derivatives, condensed aromatic ring compounds, and arylamine-substituted condensed aromatic ring compounds.

Specific examples of the dopants are illustrated below.

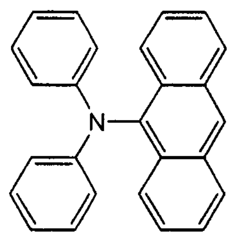

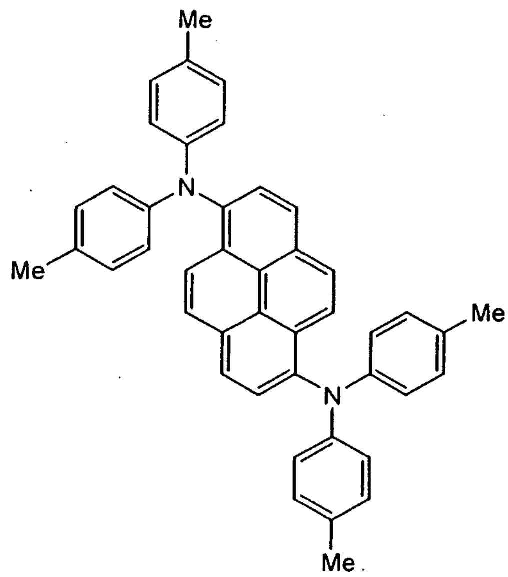

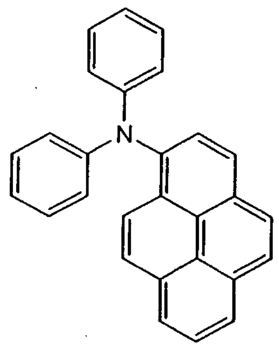

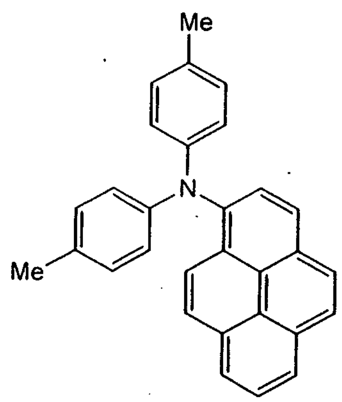

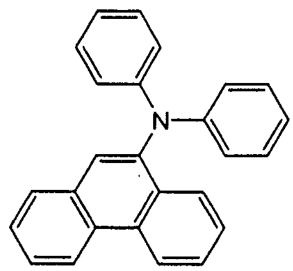

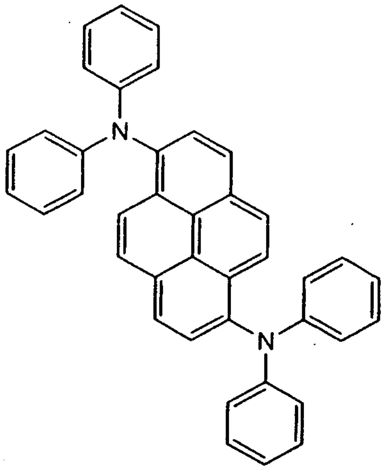

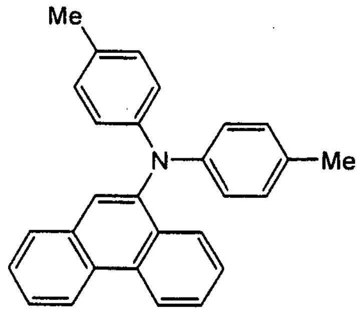

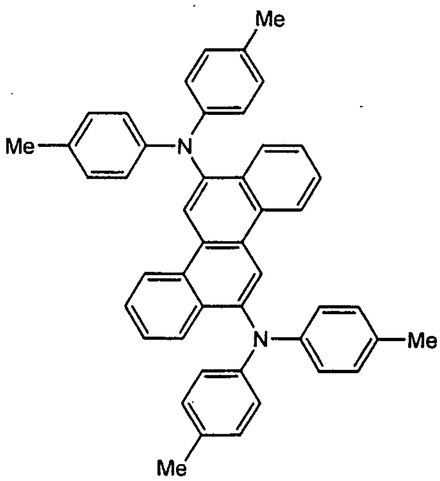

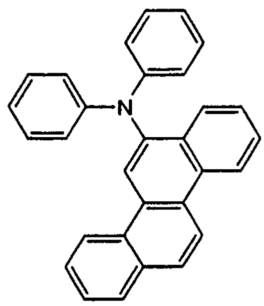

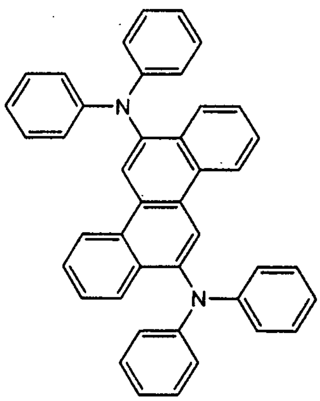

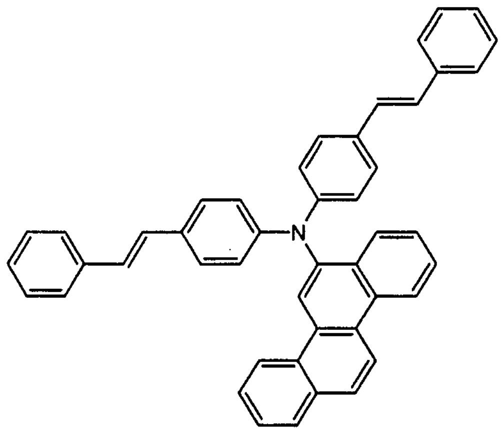

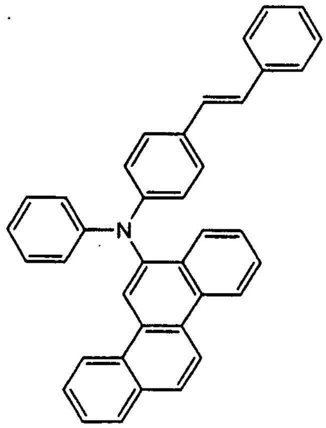

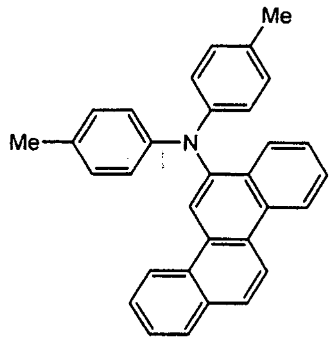

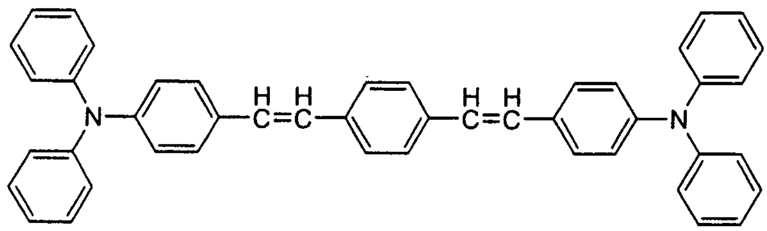

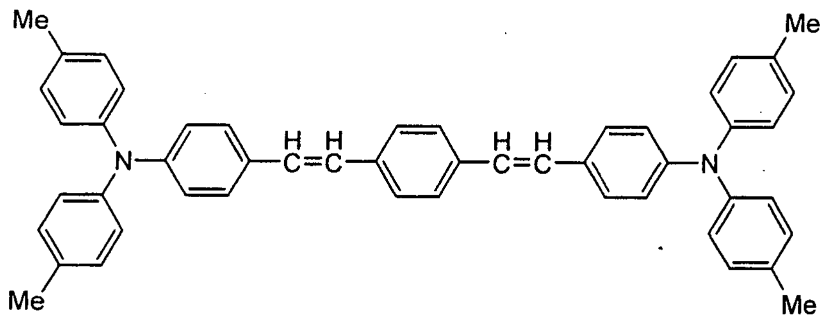

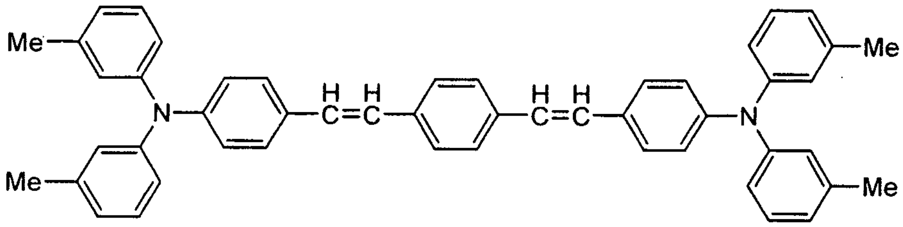

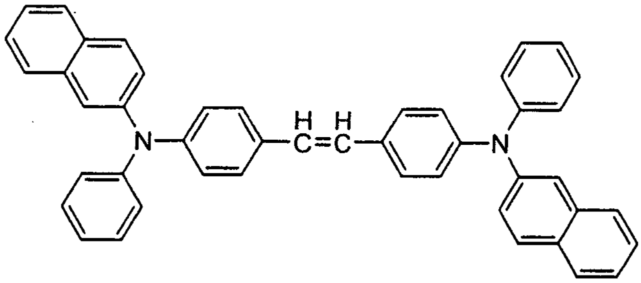

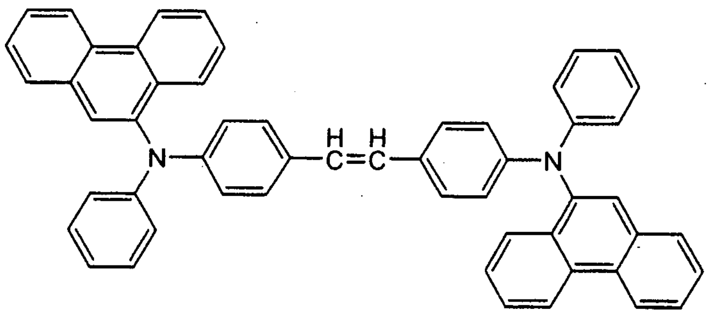

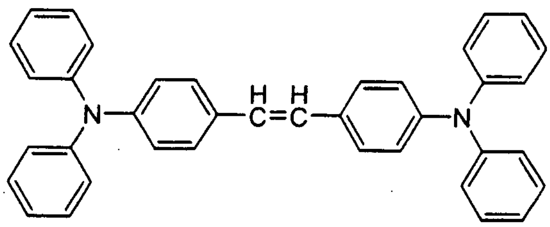

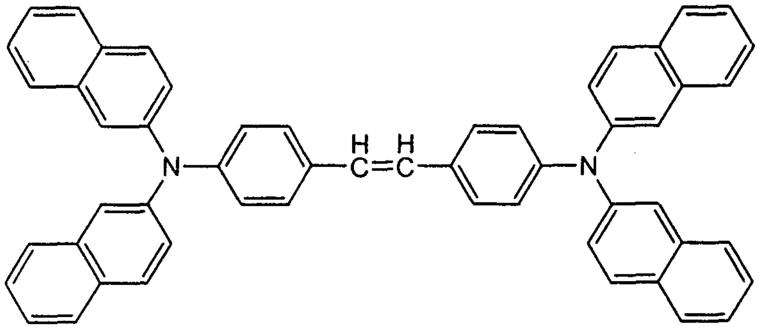

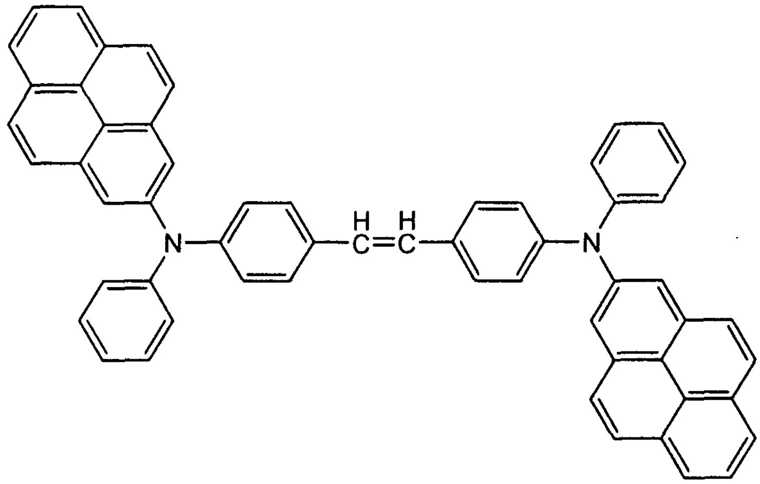

The first dopant preferably has a hole-injection-aiding property, and the second dopant preferably has an electron-injection-aiding property.

The hole-injection-aiding property is a property of improving the injection of holes into a host material. Examples of a compound having the property include styrylamine derivatives and aromatic amine derivatives.

The electron-injection-aiding property is a property of improving the injection of electrons into a host material. Examples of a compound having a property include condensed polycyclic aromatic compounds such as rubrene and perylene.

About the molecular weights of the light-emitting-layer material, the first dopant and the second dopants, at least one thereof is preferably from 100 to 1500, in particular preferably from 500 to 1000. All of the molecular weights are in particular preferably from 100 to 1500. If the molecular weights are smaller than 100, a stable thin film may not be formed. If the molecular weights are larger than 1500, the vapor deposition temperature may be too high so that the compounds may thermally decompose.

About the method for forming the light emitting layer, the light emitting layer can be formed by making an organic light-emitting material wherein the light-emitting-layer material, the first dopant and the second dopant are mixed into a thin film by vacuum deposition, sputtering, spin coating, casting or some other method. The layer is preferably formed by vacuum deposition since a homogeneous film is easily obtained and pinholes are not easily generated.

When the thin film is formed, the light-emitting-layer material, the first dopant and the second dopant are preferably mixed into a homogeneous state.

The amounts of the first and second dopants added to the whole of the light emitting layer are each preferably 20% or less by weight, in particular preferably from 1 to 10% by weight. If each of the amounts is more than 20% by weight, the concentration of the dopant is too high so that the luminescent efficiency may lower.

A compound other than the light-emitting-layer material, the first dopant and the second dopant may be added

to the light emitting layer. For example, a third dopant may be added thereto.

In the light emitting layer, at least one kind of electrons and holes is preferably transported, and both kinds of them are more preferably transported. As described above, specifically, it is preferred to use, as the light-emitting-layer material, a mixture of an electron transmitting first light-emitting-layer material and a hole transmitting second light-emitting-layer material.

As discussed previously, the organic EL element of the invention has an emitting layer between a pair of electrodes.

The specific structure of the organic EL element of the invention include the following:

i) Anode/emitting layer/cathode,
ii) Anode/hole injecting layer/emitting layer/cathode,
iii) Anode/emitting layer/electron injecting layer/cathode,
iv) Anode/hole injecting layer/emitting layer/electron injecting layer/cathode,
v) Anode/organic semiconductor layer/emitting layer/cathode,
vi) Anode/organic semiconductor layer/electron barrier layer/emitting layer/cathode,
vii) Anode/organic semiconductor layer/emitting layer/adhesion improving layer/cathode,
viii) Anode/hole injecting layer/hole transporting layer/emitting layer/electron injecting layer/cathode,
ix) Anode/insulator layer/emitting layer/insulator layer/cathode,
x) Anode/inorganic semiconductor layer/insulator layer/emitting layer/insulator layer/cathode,
xi) Anode/organic semiconductor layer/insulator layer/emitting layer/insulator layer/cathode,
xii) Anode/insulator layer/hole injecting layer/hole transporting layer/emitting layer/insulator layer/cathode, and
xiii) Anode/insulator layer/hole injecting layer/hole transporting layer/emitting layer/electron injecting layer/cathode.

Usually, the structure viii) out of these is preferably used.

Materials commonly used for parts of an organic EL element other than an emitting layer, whose materials have been described above, can be used when the organic EL element of the invention is produced.

Specific examples of the materials are described in detail below.

The organic EL element of the present invention is formed on a transparent substrate. The transparent substrate is a substrate for supporting the organic EL element, and is preferably a flat or smooth substrate having a transmittance of 50% or more to light rays within visible ranges of 400 to 700 nm.

Specific examples thereof include a glass plate and a polymer plate. Examples of the glass plate include soda-lime glass, barium/strontium-containing glass, lead glass, aluminosilicate glass, borosilicate glass, barium borosilicate glass, and quartz. Examples of the polymer plate include polycarbonate, acrylic polymer, polyethylene terephthalate, polyethersulfide, and polysulfone.

An anode is preferably made of an electrode material with a large work function (4 eV or more), which is a metal, alloy, electroconductive compound or mixture thereof. Specific examples of the electrode materials include conductive materials such as metals e.g., Au, CuI, ITO, IZO, $SnO_2$ and ZnO.

The anode can be formed by forming these electrode materials into a thin film by vapor deposition, sputtering or the like.

In the case where luminescence from the emitting layer is taken out through the anode, the transmittance of the anode to the luminescence is preferably more than 10%.

The sheet resistance of the anode is preferably several hundreds Ω/□ or less. The film thickness of the anode, which is varied in accordance with the material thereof, is usually from 10 nm to 1 μm, preferably from 10 to 200 nm.

The hole injecting, transporting layer is a layer for helping the injection of holes into the emitting layer so as to transport holes to a light emitting region. The hole mobility thereof is large and the ionization energy thereof is usually as small as 5.5 eV or less. Such a hole injecting, transporting layer is preferably made of a material which can transport holes to the emitting layer at a lower electric field intensity. The hole mobility thereof is preferably at least $10^{-4}$ $cm^2/V \cdot$second when an electric field of, e.g., $10^4$ to $10^6$ V/cm is applied.

The material for forming the hole injecting, transporting layer is not particularly limited so long as the material has the above-mentioned preferred natures. The material can be arbitrarily selected from materials which have been widely used as a hole transporting material in photoconductive materials and known materials used in a hole injecting layer of organic EL elements.

Specific examples thereof include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712

and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stylbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive oligomers (in particular thiophene oligomers) disclosed in JP-A-1-211399.

The above-mentioned substances can be used as the material of the hole injecting, transporting layer. The following are preferably used: porphyrin compounds (disclosed in JP-A-63-2956965 and others), aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others), in particular, the aromatic tertiary amine compounds.

The following can also be given as examples: 4,4'-bis (N-(1-naphthyl)-N-phenylamino)biphenyl (hereinafter abbreviated to NPD), which has in the molecule thereof two condensed aromatic rings, disclosed in USP No. 5,061,569, and 4,4',4"-tris(N-(3-methylphenyl)-N-phenylamino)triphenylamine (hereinafter abbreviated to MTDATA), wherein three triphenylamine units are linked to each other in a star-burst form, disclosed in JP-A-4-308688.

Inorganic compounds such as aromatic dimethylidene type compounds, p-type Si and p-type SiC can also be used as the material of the hole injecting, transporting layer.

The hole injecting, transporting layer can be formed by making the above-mentioned compound(s) into a thin film by a known method, such as vacuum deposition, spin coating, casting or LB technique. The film thickness of the hole injecting, transporting layer is not particularly limited, and is usually from 5 nm to 5 μm. This hole injecting, transporting layer may be a single layer made of one or more out of the above-mentioned materials. A hole injecting, transporting layer made of a compound different from that in another hole injecting, transporting layer may be laminated thereon.

In the invention, a hole injecting layer is preferably formed between an anode and an emitting layer. A compound of which the hole injecting layer is made preferably contains a phenylene diamine structure.

The organic semiconductor layer is a layer for helping the injection of holes or electrons into the emitting layer, and is preferably a layer having an electroconductivity of $10^{-10}$ S/cm or more. The material of such an organic semiconductor layer may be an electroconductive oligomer, such as thiophene-containing oligomer or arylamine-containing oligomer disclosed in JP-A-8-193191, an electroconductive dendrimer such as arylamine-containing dendrimer.

The electron injecting layer is a layer for helping the injection of electrons into the emitting layer, and has a large electron mobility. The adhesion improving layer is a layer made of a material particularly good in adhesion to the cathode among such electron injecting layers. The material used in the electron injecting layer is preferably a metal complex of 8-hydroxyquinoline or a derivative thereof.

Specific examples of the above-mentioned metal complex of 8-hydroxyquinoline or derivative include metal chelate oxynoid compounds each containing a chelate of oxine (generally, 8-quinolinol or 8-hydroxyquinoline).

For example, Alq can be used in the electron injecting layer.

Examples of the oxadiazole derivative include electron transferring compounds represented by the following general formulas [1] to [3]:

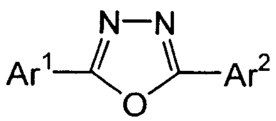

[1]

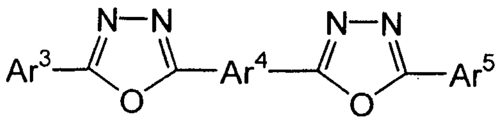

[2]

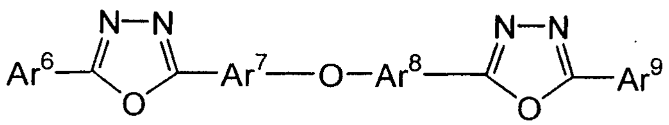

[3]

wherein $Ar^1$, $Ar^2$, $Ar^3$, $Ar^5$, $Ar^6$ and $Ar^9$ each represent a substituted or unsubstituted aryl group and may be the same as or different from each other, and $Ar^4$, $Ar^7$ and $Ar^8$ represent substituted or unsubstituted arylene groups and may be the same as or different from each other.

Examples of the aryl group include phenyl, biphenyl, anthranyl, perylenyl, and pyrenyl groups. Examples of the arylene group include phenylene, naphthylene, biphenylene, anthranylene, perylenylene, and pyrenylene groups. Examples of the substituent include alkyl groups with 1 to 10 carbons, alkoxy groups with 1 to 10 carbons, and a cyano group. The electron transferring compounds are preferably ones having capability of forming a thin film.

Specific examples of the electron transferring compounds include the following:

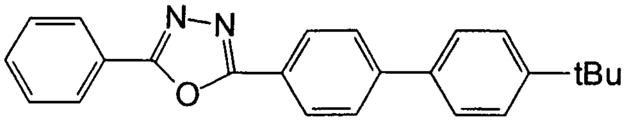

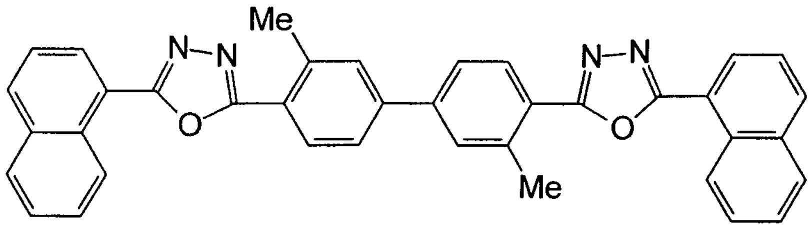

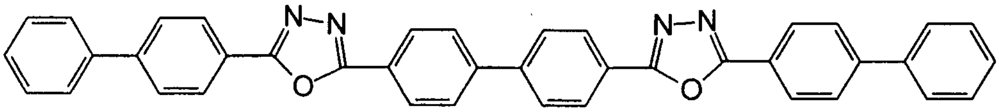

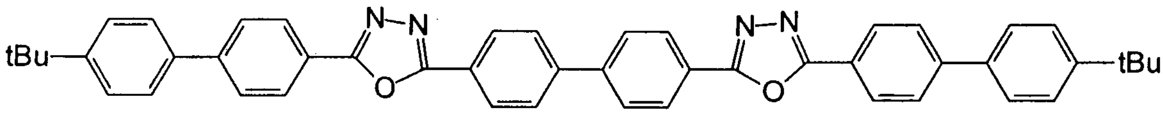

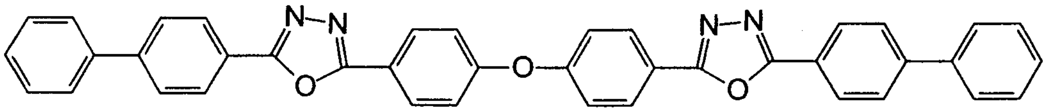

An electron injection layer may be formed which is made of an alkali metal oxide, alkaline earth metal oxide, alkali metal halide or alkaline earth metal halide. Specific examples thereof include lithium fluoride, lithium oxide, cesium fluoride, cesium oxide, magnesium oxide, magnesium fluoride, calcium oxide and calcium fluoride.

Furthermore, a small amount of an alkali metal or an alkaline earth metal may be added to an organic compound layer to form an electron injection region. The addition amount thereof is preferably from 0.1 to 10 mol%.

For the cathode, the following may be used: an electrode substance made of a metal, an alloy or an electroconductive compound which has a small work function (4 eV or less), or a mixture thereof. Specific examples of the electrode substance include sodium, sodium-potassium alloy, magnesium, lithium, magnesium/silver alloy, aluminum/aluminum oxide, aluminum/lithium alloy, indium, and rare earth metals.

This cathode can be formed by making the electrode substance(s) into a thin film by vapor deposition, sputtering or some other method.

In the case where luminescence from the emitting layer is taken out through the cathode, it is preferred to make the transmittance of the cathode to the luminescence larger than 10%.

The sheet resistance of the cathode is preferably several hundreds Ω/□ or less, and the film thickness thereof is usually from 10 nm to 1 μm, preferably from 50 to 200 nm.

In the organic EL element, pixel defects based on leakage or a short circuit are easily generated since an electric field is applied to the super thin film. In order to prevent this, it is preferred to insert an insulator thin layer between the pair of electrodes.

Examples of the material used in the insulator layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide.

A mixture or laminate thereof may be used.

The organic EL element can be produced by forming an anode and an emitting layer, optionally forming a hole injecting layer and an electron injecting layer, and further forming a cathode by use of the materials and methods exemplified above. The organic EL element can be produced in the order reverse to the above, i.e., the order from a cathode to an anode.

An example of the production of the organic EL element will be described below which has a structure wherein the following are successively formed over a transparent substrate: anode/hole injecting layer/emitting layer/electron injecting layer/cathode.

First, a thin film made of an anode material is formed into a thickness of 1 μm or less, preferably 10 to 200 nm on an appropriate transparent substrate by vapor deposition, sputtering or some other method, thereby forming an anode.

Next, a hole injecting layer is formed on this anode. As described above, the hole injecting layer can be formed by vacuum deposition, spin coating, casting, LB technique, or some other method. Vacuum deposition is preferred since a homogenous film is easily obtained and pinholes are not easily generated. In the case where the hole injecting layer is formed by vacuum deposition, conditions for the deposition are varied in accordance with the used compound (the material for the hole injecting layer), the crystal structure or recombining structure of the hole injecting layer, and others. In general, the conditions are appropriately selected from the following: deposition source temperatures of 50 to 450°C, vacuum degrees of $10^{-7}$ to $10^{-3}$ torr, vapor deposition rates of 0.01 to 50 nm/second, substrate temperatures of -50 to 300°C, and film thicknesses of 5 nm to 5 μm.

Next, an emitting layer is disposed on the hole injecting layer. The emitting layer can be formed by using a desired organic luminescent material and making the material into a thin film by vacuum deposition, sputtering, spin coating, casting or some other method. Vacuum deposition is preferred since a homogenous film is easily obtained and pinholes are not easily generated. In the case where the emitting layer is formed by vacuum deposition, conditions for the deposition, which are varied dependently on the used compound, can be generally selected from conditions similar to those for the hole injecting layer.

Next, an electron injecting layer is formed on this emitting layer. Like the hole injecting layer and the emitting layer, the layer is preferably formed by vacuum deposition in order to obtain a homogenous film. Conditions for the deposition can be selected from conditions similar to those for the hole injecting layer and the emitting layer.

Lastly, a cathode is laminated thereon to obtain an organic EL element.

The cathode is made of a metal, and vapor deposition or sputtering may be used. However, vacuum deposition is preferred in order to protect underlying organic layers from being damaged when the cathode film is formed.

About the organic EL element production that has been described so far, it is preferred that the formation from the anode to the cathode is continuously carried out, using only one vacuuming operation.

In the case where a DC voltage is applied to the organic EL element, luminescence can be observed when the polarity of the anode and that of the cathode are made positive and negative, respectively, and the voltage of 5 to 40 V is applied. Even if a voltage is applied thereto in the state that the polarities are reverse to the above, no electric current flows so that luminescence is not generated at all. In the case where an AC voltage is applied thereto, uniform luminescence can be observed only when the polarity of the anode and that of the cathode are made positive and negative, respectively. The waveform of the AC to be applied may be arbitrarily selected.

The organic EL element of the invention has an improved luminance, light emitting efficiency or durability. Thus, the organic EL element is suitably used as a light source such as a flat illuminant of wall-hanging television and a backlight of a display, a display of cell phone and PDA, a car navigation, an instrument panel of car and an illumination.

## Examples

The invention will be explained with reference to examples hereinafter, while the invention shall not be limited

to the following examples.

In each example, the properties of compounds used and organic EL elements produced were evaluated in the following ways.

(1) Valence electron level: It was measured with a photoelectron spectroscopic instrument (AC-1, Riken Keiki Co., LTD) in air. Specifically, light was irradiated to a material and the amount of electrons generated by charge separation was measured.
(2) Energy gap: It was measured based on an absorption edge of an absorption spectrum in benzene. Specifically, an absorption spectrum was measured with a commercially available ultraviolet-visible spectrophotometer. The energy gap was calculated from the wavelength in which the spectrum begins to raise.
(3) Conduction level: It was calculated from the measured values of a valence electron level and an energy gap.
(4) Luminance: It was measured with a spectro radio luminance meter (CS-1000, MINOLTA Co., Ltd.).
(5) Efficiency: It was calculated from a current density and a luminance (100 nit) measured with a multimeter.
(6) Half life: For an element sealed, it was measured at room temperature at 1000 nit of an initial luminance and constant current.

The formulas of compounds used in examples and comparative examples are shown below.
The valence electron levels, conduction levels and energy gaps of these compounds are shown to Table 1.

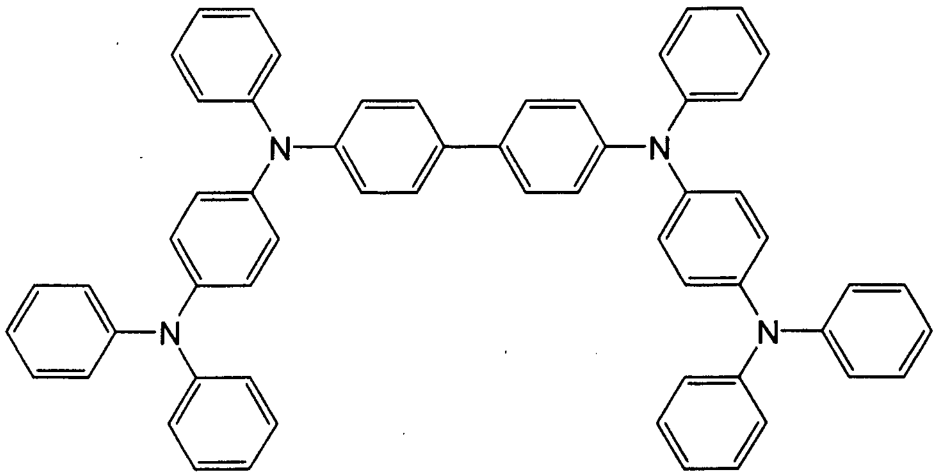

TPD232

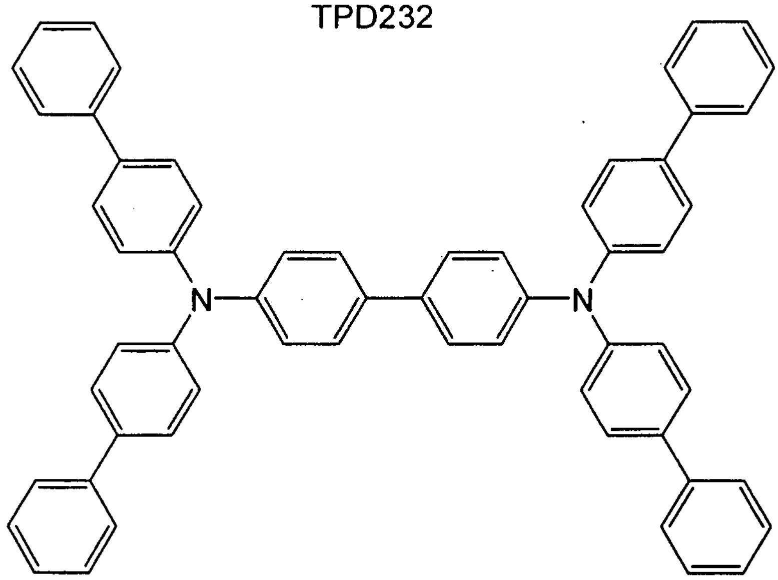

TBDB

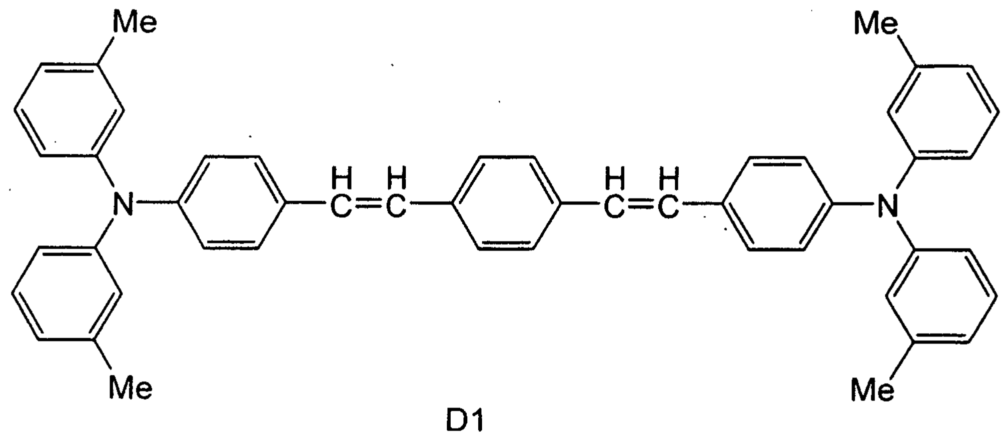

D1

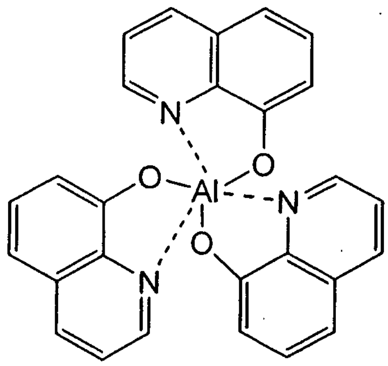

Alq

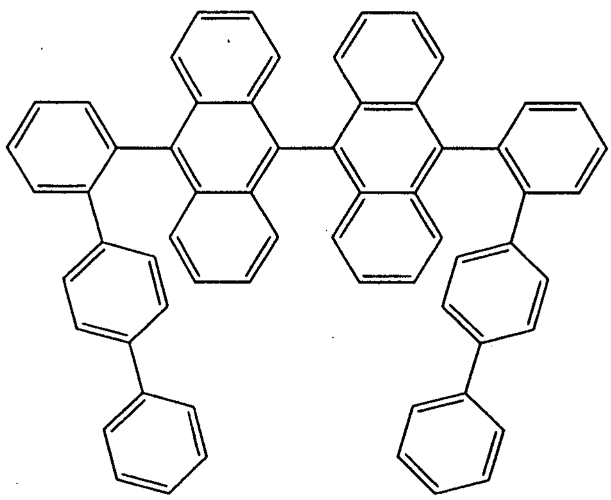

H1

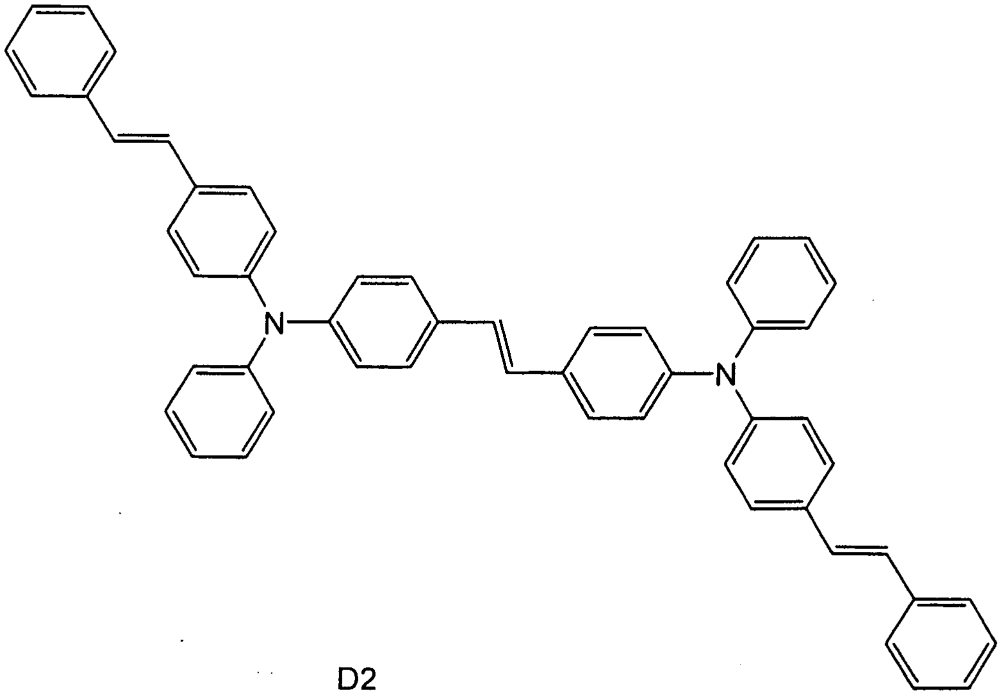

D2

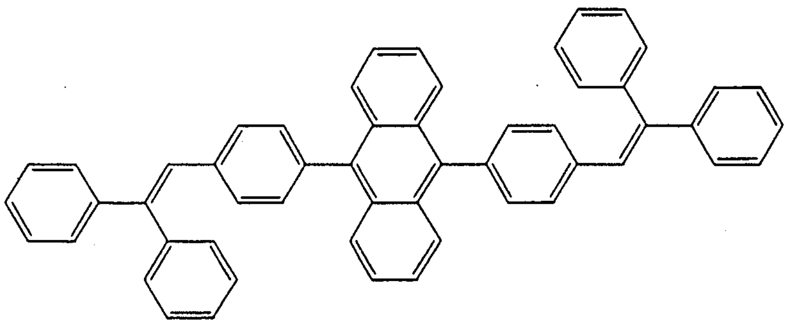

H2

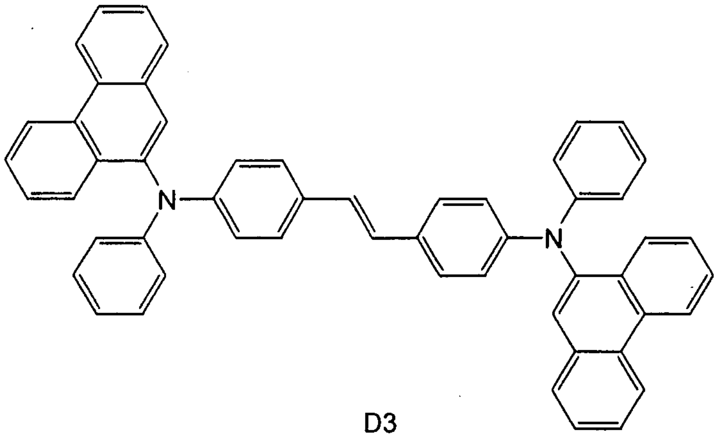

D3

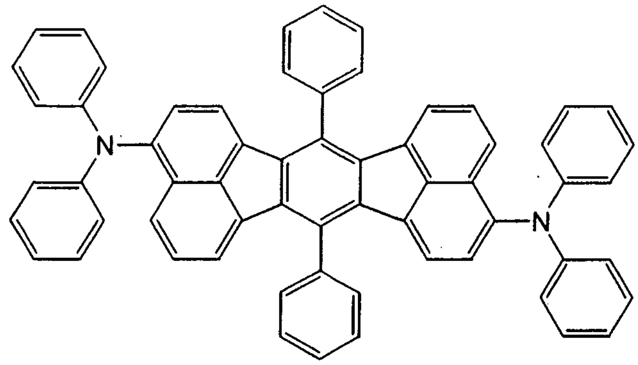

D4

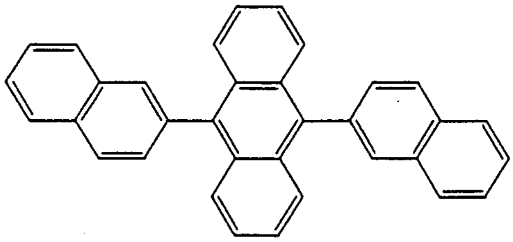

H3

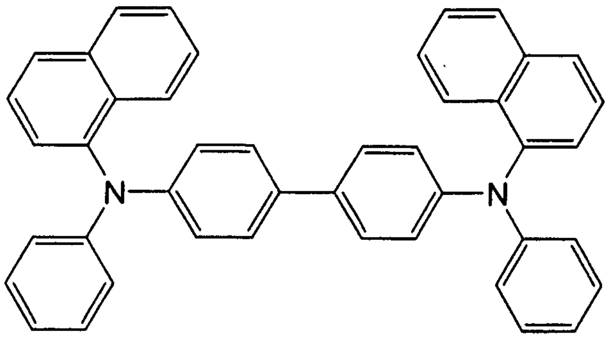

NPB

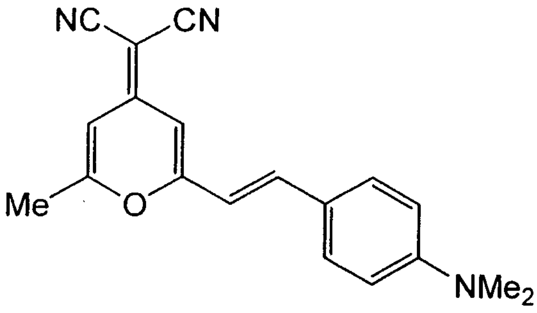

D5

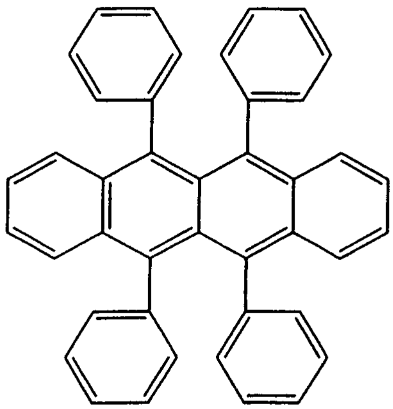

D6

Table 1

| Compound | Valence electron level (EC) | Conduction Level (EC) | Energy Gap (EC) |
|---|---|---|---|
| H1 | 5.7 | 2.7 | 3.0 |
| H2 | 5.7 | 2.8 | 2.9 |
| H3 | 5.7 | 2.7 | 3.0 |
| D1 | 5.5 | 2.7 | 2.8 |
| D2 | 5.4 | 2.6 | 2.8 |
| D3 | 5.4 | 2.5 | 2.9 |
| D4 | 5.6 | 3.0 | 2.6 |
| D5 | 5.2 | 3.1 | 2.1 |
| D6 | 5.3 | 3.1 | 2.2 |
| NPB | 5.4 | 2.3 | 3.1 |

Example 1

A glass substrate of 25 mm by 75 mm by 1.1 mm with an ITO transparence electrode (GEOMATEC CO., LTD.) was subjected to ultrasonic cleaning with isopropyl alcohol for 5 minutes, and cleaned with ultraviolet rays and ozone for 30 minutes.

The resultant substrate was mounted on a substrate holder in a vacuum deposition device. First, a film of N, N'-bis(N,N'-diphenyl-4-aminophenyl)-N,N'-diphenyl-4,4'-diamino-1,1'-biphenyl (TPD232 film), having a film thickness of 60 nm, was formed so as to cover the surface of the transparence electrode on which transparence electrode lines were formed. The TPD232 film functions as a hole injecting layer.

After forming the TPD232 film, a layer of N,N,N',N'-tetra(4-biphenyl)-diaminobiphenylene (TBDB layer), having a film thickness of 20 nm, was formed on the TPD232 film. The film functions as a hole transporting layer.

Thereafter H1 as a light-emitting-layer material, D1 as a first dopant and D2 as a second dopant were deposited to form a 40nm-thick film such that D1:D2:H1 (weight ratio) was 1:1:40. The film functions as a light emitting layer.

Next, an Alq film with a film thickness of 10 nm was formed on the film. The Alq film functions as an electron injecting layer.

Thereafter Alq and lithium as a reductive dopant (lithium source: Saesgetter Co., Ltd.) were co-deposited to form an Alq:Li film (film thickness of 10nm) as an electron injecting layer (cathode). Metal aluminum was deposited on this Alq:Li film to form a metallic cathode, thereby forming an organic EL element.

Comparative Example 1

An organic EL element was produced in the same way as Example 1 except that H2 was used instead of H1, and D3 was used instead of D1.

Comparative Example 2

An organic EL element was produced in the same way as Example 2 except that D1 was used instead of D2.

Example 2

An organic EL element was produced in the same way as Example 1 except that D2 was used instead of D1, and D4 was used instead of D2.

Example 3

An organic EL element was produced in the same way as Example 1 except that H3 was used instead of H1.

Comparative Example 3

An organic EL element was produced in the same way as Example 1 except that D2 was not used.

Comparative Example 4

An organic EL element was produced in the same way as Example 1 except D1 was not used.

Comparative Example 5

An organic EL element was produced in the same way as Example 1 except that NPB was used instead of D2.

Comparative Example 6

An organic EL element was produced in the same way as Comparative Example 1 except that D1 was not used.

Comparative Example 7

An organic EL element was produced in the same way as Comparative Example 1 except that D3 was not used.

Comparative Example 8

An organic EL element was produced in the same way as Comparative Example 2 except that D3 was not used.

Comparative Example 9

An organic EL element was produced in the same way as Example 2 except that D2 was not used.

Comparative Example 10

An organic EL element was produced in the same way as Example 3 except that D2 was not used.

Comparative Example 11

An organic EL element was produced in the same way as Example 3 except that D1 was not used.

Comparative Example 12

An organic EL element was produced in the same way as Example 1 except that D5 was used instead of D1, and D6 was used instead of D2.

Comparative Example 13

An organic EL element was produced in the same way as Example 1 except that D5 was used instead of D1, and NPB was used instead of D2.

In the organic EL elements produced in Examples 1 to 3 and Comparative Examples 1 to 13, light-emitting-layer materials used; and each kind, valence electron level and conduction level of the first dopants and the second dopants used are shown in Table 2.

Table 2

| | Light emitting layer material | | First dopant | | Second dopant | |
|---|---|---|---|---|---|---|
| Exam. 1 | H1 | EV0:5.7<br>EC0:2.7<br>Eg0:3.0 | D1 | EV1:5.5<br>EC1:2.7<br>Eg1:2.8 | D2 | EV2:5.4<br>EC2:2.6<br>Eg2:2.8 |
| Com. Exam. 1 | H2 | EV0: 5.7<br>EC0:2.8<br>Eg0:2.9 | D1 | EV1:5.5<br>EC1:2.7<br>Eg1:2.8 | D3 | EV2:5.4<br>EC2:2.5<br>Eg2:2.9 |
| Com. Exam. 2 | H2 | EV0:5.7<br>EC0:2.8<br>Eg0:2.9 | D2 | EV1:5.4<br>EC1:2.6<br>Eg1:2.8 | D3 | EV2:5.4<br>EC2:2.5<br>Eg2:2.9 |
| Exam. 2 | H1 | EV0:5.7<br>EC0:2.7<br>Eg0:3.0 | D4 | EV1:5.6<br>EC1:3.0<br>Eg1:2.6 | D2 | EV2:5.4<br>EC2:2.6<br>Eg2:2.8 |
| Exam. 3 | H3 | EV0:5.7<br>EC0:2.7<br>Eg0:3.0 | D1 | EV1:5.5<br>EC1:2.7<br>Eg1:2.8 | D2 | EV2:5.4<br>EC2:2.6<br>Eg2:2.8 |
| Com. Exam. 3 | H1 | EV0:5.7<br>EC0:2.7<br>Eg0:3.0 | D1 | EV1:5.5<br>EC1:2.7<br>Eg1:2.8 | none | |
| Com. Exam. 4 | H1 | EV0:5.7<br>EC0:2.7<br>Eg0:3.0 | none | | D2 | EV2:5.4<br>EC2:2.6<br>Eg2:2.8 |

(continued)

| | Light emitting layer material | | First dopant | | Second dopant | |
|---|---|---|---|---|---|---|
| Com. Exam. 5 | H1 | EV0:5.7<br>EC0:2.7<br>Eg0:3.0 | D1 | EV1:5.5<br>EC1:2.7<br>Eg1:2.8 | NPB | EV2:5.4<br>EC2:2.3<br>Eg2:3.1 |
| Exam. 6 | H2 | EV0:5.7<br>EC0:2.8<br>Eg0:2.9 | none | | D3 | EV2:5.4<br>EC2:2.5<br>Eg2:2.9 |
| Com. Exam. 7 | H2 | EV0:5.7<br>EC0:2.8<br>Eg0:2:9 | D1 | EV1:5.5<br>EC1:2.7<br>Eg1:2.8 | none | |
| Com. Exam. 8 | H2 | EV0:5.7<br>EC0:2.8<br>Eg0:2.9 | none | | D2 | EV1:5.4<br>EC1:2.6<br>Eg1:2.8 |
| Com. Exam. 9 | H1 | EV0:5.7<br>EC0:2.7<br>Eg0:3.0 | D4 | EV1:5.6<br>EC1:3.0<br>Eg1:2.6 | none | |
| Com. Exam. 10 | H3 | EV0:5.7<br>EC0:2.7<br>Eg0:3.0 | D1 | EV1:5.5<br>EC1:2.7<br>Eg1:2.8 | none | |
| Com. Exam. 11 | H3 | EV0:5.7<br>EC0:2.7<br>Eg0:3.0 | none | | D2 | EV2:5.4<br>EC2:2.6<br>Eg2:2.8 |
| Com. Exam. 12 | H1 | EV10:5.7<br>EC0:2.7<br>Eg0:3.0 | D5 | EV1:5.2<br>EC1:3.1<br>Eg1:2.1 | D6 | EV2:5.3<br>EC2:3.1<br>Eg2:2.2 |
| Com. Exam. 13 | H1 | EV0:5.7<br>EC0:2.7<br>Eg0:3.0 | D5 | EV1:5.2<br>EC1:3.1<br>Eg1:2.1 | NPB | EV2:5.4<br>EC2:2.3<br>Eg2:3.1 |

Evaluation example

The organic EL elements produced in examples 1 to 3 and comparative examples 1 to 13, were evaluated for a luminescent efficiency at a luminance near 100 nit, and a half life at 1000 nit of an initial luminance. Evaluation results were shown in Table 3.

Table 3

| | Driving voltage (V) @100 nit | Light emitting efficiency (cd · A) @100 nit | Half life (h) @1000 nit | Color of emitted light |
|---|---|---|---|---|
| Exam. 1 | 5.0 | 12.3 | 15000 | blue |
| Com. Exam. 3 | 5.1 | 12.1 | 7000 | blue |
| Com. Exam. 4 | 5.5 | 6.0 | 6000 | pure blue |
| Com. Exam. 5 | 5.2 | 12.0 | 7000 | blue |
| Com. Exam. 1 | 4.9 | 12.2 | 8000 | blue |
| Com. Exam. 6 | 5.6 | 4.4 | 800 | pure blue |
| Com. Exam. 7 | 5.1 | 8.3 | 3000 | blue |

(continued)

| | Driving voltage (V) @100 nit | Light emitting efficiency (cd · A) @100 nit | Half life (h) @1000 nit | Color of emitted light |
|---|---|---|---|---|
| Com. Exam. 2 | 5.4 | 6.3 | 3000 | pure blue |
| Com. Exam. 6 | 5.6 | 4.4 | 800 | pure blue |
| Com. Exam. 8 | 5.6 | 4.7 | 700 | pure blue |
| Exam. 2 | 5.5 | 11.2 | 20000 | yerrow |
| Com. Exam. 4 | 5.5 | 6.0 | 6000 | pure blue |
| Com. Exam. 9 | 5.4 | 9.3 | 12000 | yerrow |
| Exam. 3 | 4.6 | 9.8 | 3700 | blue |
| Com. Exam. 10 | 4.7 | 9.4 | 2800 | blue |
| Com. Exam. 11 | 5.2 | 5.0 | 500 | pure blue |
| Com. Exam. 12 | 8.0 | 6.4 | 3000 | orange |
| Com. 13 Exam. | 7.7 | 6.2 | 5000 | orange |

The results of Example 1 and Comparative Examples 3 to 5, Example 2 and Comparative Examples 4 and 9, Example 3 and Comparative Examples 10 and 11, shown in Table 3, disclosed that the element of the present invention had a high light emitting efficiency and a remarkably long durability.

Industrial Utility

The present invention can provide an organic electroluminescence element having a high luminance, a high efficiency and a long durability.

**Claims**

1. An organic electroluminescence element comprising:

    a pair of electrodes, and
    a light emitting layer provided between the pair of electrodes, the layer comprising a light-emitting-layer material, a first dopant and a second dopant that satisfy the following relations,

$$(A)\ EV0 > EV1 \text{ and } EV0 > EV2$$

$$(B)\ EC0 \geq EC2$$

$$(C)\ EG0 > EG1 \text{ and } EG0 > EG2$$

    wherein EV0, EV1 and EV2 are the valence electron levels of the light-emitting-layer material, the first dopant and the second dopant, respectively; EC0 and EC2 are the conduction levels of the light-emitting-layer material and the second dopant, respectively; and EG0, EG1 and EG2 are the energy gaps of the light-emitting-layer material, the first dopant and the second dopant, respectively;
    said valence electron level corresponding to the HOMO and said conduction level corresponding to the LUMO.

2. The organic electroluminescence element according to claim 1, comprising the light-emitting-layer material, the first dopant and the second dopant satisfying the following relation,

$$EC0 \geq EC1$$

wherein EC0 and EC1 are the conduction levels of the light-emitting-layer material and the first dopant, respectively.

3. The organic electroluminescence element according to claim 1 or 2, wherein both the first dopant and the second dopant emit light.

4. The organic electroluminescence element according to claim 1 or 2, wherein the content of the first dopant and/or the second dopant is 20 wt% or less of the entire light emitting layer.

5. The organic electroluminescence element according to claim 1 or 2, wherein the first dopant has a hole-injection-aiding property, and/or the second dopant has an electron-injection-aiding property.

6. The organic electroluminescence element according to claim 1 or 2, wherein the difference between the valence electron level EV0 of the light-emitting-layer material and the valence electron level EV1 of the first dopant is 0.4 eV or less and/or the difference between the conduction level EC0 of the light-emitting-layer material and the conduction level EC2 of the second dopant is 0.4 eV or less.

7. The organic electroluminescence element according to claim 1 or 2, wherein the molecular weight of at least one of the light-emitting-layer material, the first dopant and the second dopant is from 100 to 1,500.

8. The organic electroluminescence element according to claim 1 or 2, wherein the glass-transition temperature of the light-emitting-layer material is 100°C or more.

9. The organic electroluminescence element according to claim 1 or 2, wherein the first dopant or the second dopant is selected from styrylamine derivatives, condensed aromatic ring compounds and arylamine-substitued condensed aromatic ring compounds.

10. The organic electroluminescence element according to claim 1 or 2, wherein the light-emitting-layer material comprises a compound having a hole transporting property and/or a compound having an electron transporting property.

11. The organic electroluminescence element according to claim 1 or 2, wherein the light-emitting-layer material is selected from phenylanthracene derivatives, naphthylanthracene derivatives, diphenylanthracene derivatives, aromatic amine derivatives and metal complexes.

12. The organic electroluminescence element according to claim 11, wherein the phenylanthracene derivatives, the naphthylanthracene derivatives or the diphenylanthracene derivatives contain an alkenyl group.

13. The organic electroluminescence element according to claim 1 or 2, further comprising a hole injecting layer between the anode and the light emitting layer; the hole injecting layer comprising a compound having a phenylenediamine structure.

**Patentansprüche**

1. Organisches Elektrolumineszenzelement, umfassend
ein Paar Elektroden, und
eine zwischen dem Elektrodenpaar vorgesehene lichtemittierende Schicht, wobei die Schicht ein lichtemittierendes Schichtmaterial, ein erstes Dotierungsmittel und ein zweites Dotierungsmittel umfasst, die die folgenden Beziehungen erfüllen,

$$\text{(A) } EV0 > EV1 \text{ und } EV0 > EV2$$

$$(B)\ EC0 \geq EC2$$

$$(C)\ EG0 > EG1 \text{ und } EG0 > EG2$$

wobei EV0, EV1 und EV2 die Valenzelektronenniveaus des lichtemittierenden Schichtmaterials, des ersten Dotierungsmittels bzw. des zweiten Dotierungsmittels sind; EC0 und EC2 die Leitniveaus des lichtemittierenden Schichtmaterials bzw. des zweiten Dotierungsmittels sind, und EG0, EG1 und EG2 jeweils die Energielücken des lichtemittierenden Schichtmaterials, des ersten Dotierungsmittels bzw. des zweiten Dotierungsmittels sind;
wobei das Valenzelektronenniveau dem HOMO und das Leitniveau dem LUMO entspricht.

**2.** Organisches Elektrolumineszenzelement nach Anspruch 1, umfassend das lichtemittierende Schichtmaterial, das erste Dotierungsmittel und das zweite Dotierungsmittel, die die folgende Beziehung erfüllen

$$EC0 \geq EC1$$

wobei EC0 und EC1 die Leitniveaus des lichtemittierenden Schichtmaterials bzw. des ersten Dotierungsmittels sind.

**3.** Organisches Elektrolumineszenzelement nach Anspruch 1 oder 2, wobei sowohl das erste Dotierungsmittel als auch das zweite Dotierungsmittel Licht emittieren.

**4.** Organisches Elektrolumineszenzelement nach Anspruch 1 oder 2, wobei der Anteil am ersten Dotierungsmittel und/oder zweiten Dotierungsmittel 20 Gew.-% oder weniger der gesamten lichtemittierenden Schicht beträgt.

**5.** Organisches Elektrolumineszenzelement nach Anspruch 1 oder 2, wobei das erste Dotierungsmittel eine lochinjektionsunterstützende Eigenschaft aufweist, und/oder das zweite Dotierungsmittel eine elektroneninjektionsunterstützende Eigenschaft aufweist.

**6.** Organisches Elektrolumineszenzelement nach Anspruch 1 oder 2, wobei die Differenz zwischen dem Valenzelektronenniveau EV0 des lichtemittierenden Schichtmaterials und des Valenzelektronenniveaus EV1 des ersten Dotierungsmittels 0,4 eV oder weniger beträgt und/oder die Differenz zwischen dem Leitniveau EC0 des lichtemittierenden Schichtmaterials und dem Leitniveau EC2 des zweiten Dotierungsmittels 0,4 eV oder weniger beträgt.

**7.** Organisches Elektrolumineszenzelement nach Anspruch 1 oder 2, wobei das Molekulargewicht von mindestens einem des lichtemittierenden Materials, des ersten Dotierungsmittels und des zweiten Dotierungsmittels 100 bis 1.500 beträgt.

**8.** Organisches Elektrolumineszenzelement nach Anspruch 1 oder 2, wobei die Glasübergangstemperatur des lichtemittierenden Schichtmaterials 100°C oder mehr beträgt.

**9.** Organisches Elektrolumineszenzelement nach Anspruch 1 oder 2, wobei das erste Dotierungsmittel und das zweite Dotierungsmittel ausgewählt werden aus Styrylaminderivaten, kondensierten aromatischen Ringverbindungen und Arylamin-substituierten kondensierten aromatischen Ringverbindungen.

**10.** Organisches Elektrolumineszenzelement nach Anspruch 1 oder 2, wobei das lichtemittierende Schichtmaterial eine Verbindung umfasst, die eine Lochtransporteigenschaft aufweist, und/oder eine Verbindung, die eine Elektronentransporteigenschaft aufweist.

**11.** Organisches Elektrolumineszenzelement nach Anspruch 1 oder 2, wobei das lichtemittierende Schichtmaterial ausgewählt wird aus Phenylanthrancenderivaten, Naphthylanthracenderivaten, Diphenylanthracenderivaten, aromatischen Aminderivaten und Metallkomplexen.

**12.** Organisches Elektrolumineszenzelement nach Anspruch 11, wobei die Phenylanthracenderivate, die Naphthylanthracenderivate oder die Diphenylanthracenderivate eine Alkenylgruppe enthalten.

**13.** Organisches Elektrolumineszenzelement nach Anspruch 1 oder 2, darüber hinaus umfassend eine Lochinjektionsschicht zwischen der Anode und der lichtemittierenden Schicht; wobei die Lochinjektionsschicht eine Verbindung mit einer Phenylendiaminstruktur umfasst.

**Revendications**

**1.** Élément électroluminescent organique comprenant :

une paire d' électrodes ; et
une couche électroluminescente disposée entre les électrodes de la paire d'électrodes, la couche comprenant un matériau de couche électroluminescente, un premier dopant et un second dopant qui satisfont aux relations suivantes :

$$\text{(A)} \quad EV0 > EV1 \text{ et } EV0 > EV2$$

$$\text{(B)} \quad EC0 \geq EC2$$

$$\text{(C)} \quad EG0 > EG1 \text{ et } EG0 > EG2$$

dans lesquelles EV0, EV1 et EV2 sont les niveaux d'électron de valence du matériau de couche électroluminescente, du premier dopant et du second dopant, respectivement ; EC0 et EC2 sont les niveaux de conduction du matériau de couche électroluminescente et du second dopant, respectivement ; et EG0, EG1 et EG2 sont les bandes interdites du matériau de couche électroluminescente, du premier dopant et du second dopant, respectivement ;
ledit niveau d'électron de valence correspondant à HOMO et ledit niveau de conduction correspondant à LUMO.

**2.** Élément électroluminescent organique selon la revendication 1, comprenant le matériau de couche électroluminescente, le premier dopant et le second dopant qui satisfont à la relation suivante :

$$EC0 \geq EC1$$

dans laquelle EC0 et EC1 sont les niveaux de conduction du matériau de couche électroluminescente et du premier dopant, respectivement.

**3.** Élément électroluminescent organique selon la revendication 1 ou la revendication 2, dans lequel le premier dopant et le second dopant émettent de la lumière.

**4.** Élément électroluminescent organique selon la revendication 1 ou la revendication 2, dans lequel la teneur en premier dopant et/ou en second dopant est égale à 20 % en poids ou à moins de toute la couche électroluminescente.

**5.** Élément électroluminescent organique selon la revendication 1 ou la revendication 2, dans lequel le premier dopant présente une propriété qui facilite une injection de trous, et/ou le second dopant présente une propriété qui facilite une injection d'électrons.

**6.** Élément électroluminescent organique selon la revendication 1 ou la revendication 2, dans lequel la différence entre le niveau d'électron de valence EV0 du matériau de couche électroluminescente et le niveau d'électron de valence

EV1 du premier dopant est égale à 0,4 eV ou à moins, et/ou la différence entre le niveau de conduction EC0 du matériau de couche électroluminescente et le niveau de conduction EC2 du second dopant est égale à 0,4 eV ou à moins.

**7.** Élément électroluminescent Organique selon la revendication 1 ou la revendication 2, dans lequel le poids moléculaire de l'un au moins du matériau de couche électroluminescente, du premier dopant et du second dopant est compris entre 100 et 1500.

**8.** Élément électroluminescent organique selon la revendication 1 ou la revendication 2, dans lequel la température de transition vitreuse du matériau de couche électroluminescente est égale à 100 °C ou à plus.

**9.** Élément électroluminescent organique selon la revendication 1 ou la revendication 2, dans lequel le premier dopant ou le second dopant est sélectionné dans le groupe constitué par des dérivés de styrylamine, des composés d'anneaux aromatiques condensés et des composés d'anneaux aromatiques condensés substitués par arylamine.

**10.** Élément électroluminescent organique selon la revendication 1 ou la revendication 2, dans lequel le matériau de couche électroluminescente comprend un composé qui présente une propriété de transport de trous et/ou un composé qui présente une propriété de transport d'électrons.

**11.** Élément électroluminescent organique selon la revendication 1 ou la revendication 2, dans lequel le matériau de couche électroluminescente est sélectionné dans le groupe constitué par des dérivés de phénylanthracène, des dérivés de naphthylanthracène, des dérivés de diphénylanthracène, des dérivés amines aromatiques et des composés métalliques.

**12.** Élément électroluminescent organique selon la revendication 11, dans lequel les dérivés de phénylanthracène, les dérivés de naphthylanthracène ou les dérivés de diphénylanthracène contiennent un groupe alkényl.

**13.** Élément électroluminescent organique selon la revendication 1 ou la revendication 2, comprenant en outre une couche d'injection de trous située entre l'anode et la couche électroluminescente ; la couche d'injection de trous comprenant un composé qui présente une structure de phénylènediamine.

Fig. 1

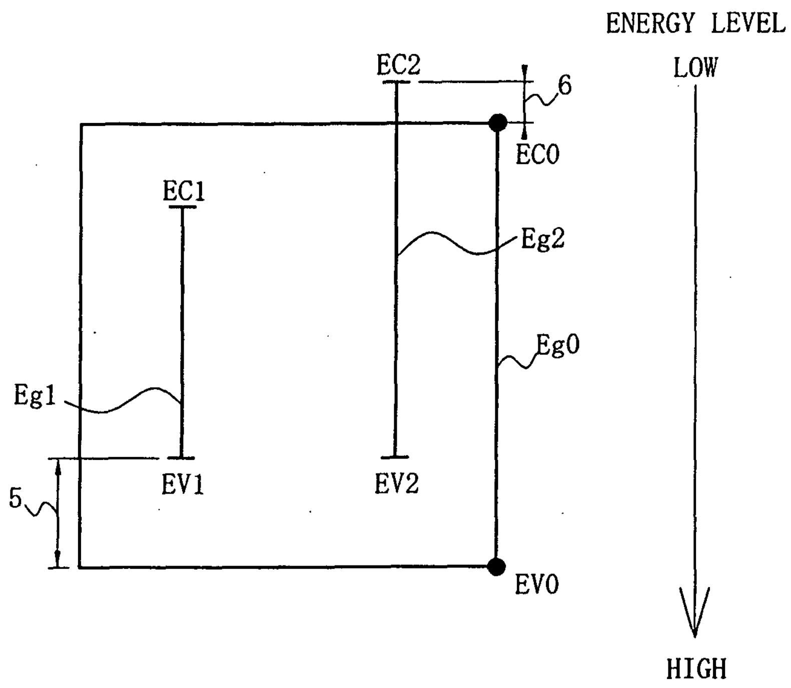
ENERGY LEVEL
LOW
EC2
6
EC0
EC1
Eg2
Eg0
Eg1
EV1
EV2
5
EV0
HIGH

Fig. 2

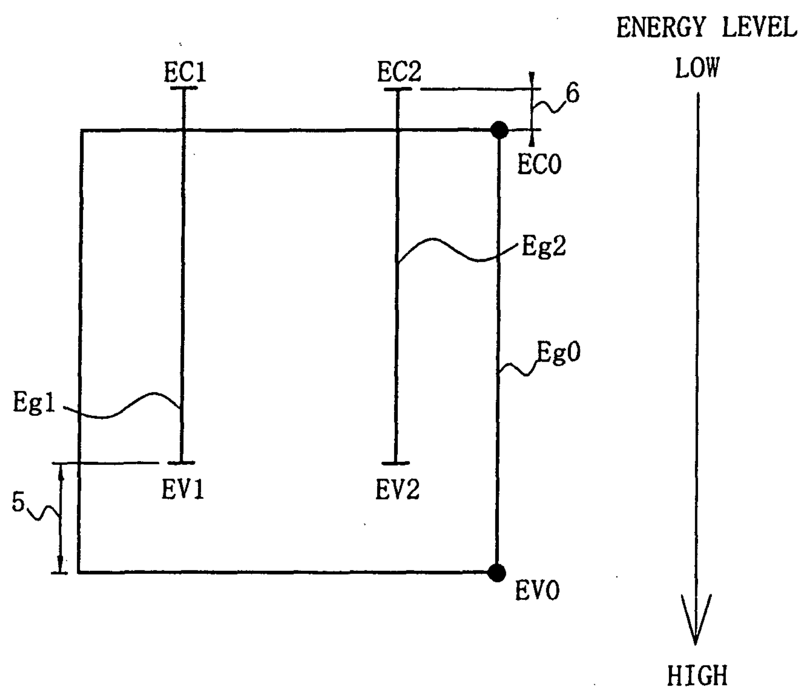
ENERGY LEVEL
LOW
EC1
EC2
6
EC0
Eg2
Eg0
Eg1
EV1
EV2
5
EV0
HIGH

Fig. 3

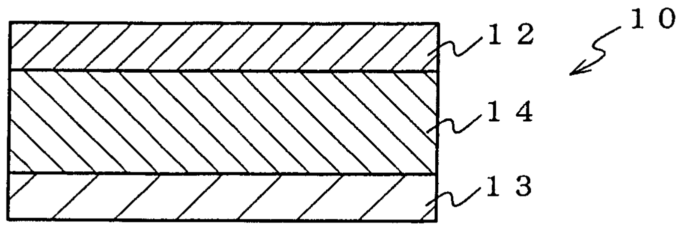
10
12
14
13

Fig. 4

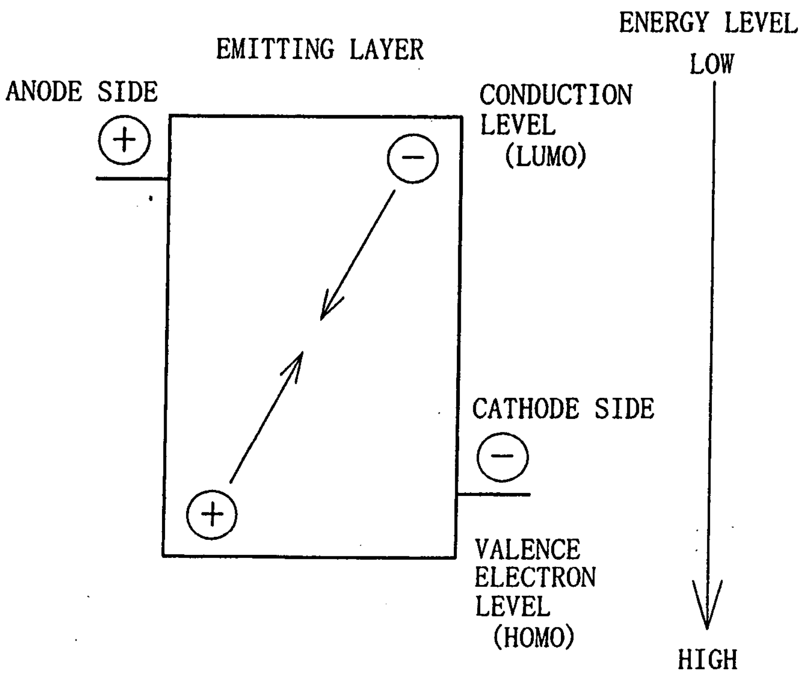
ENERGY LEVEL
LOW
EMITTING LAYER
ANODE SIDE
CONDUCTION LEVEL (LUMO)
CATHODE SIDE
VALENCE ELECTRON LEVEL (HOMO)
HIGH

Fig. 5

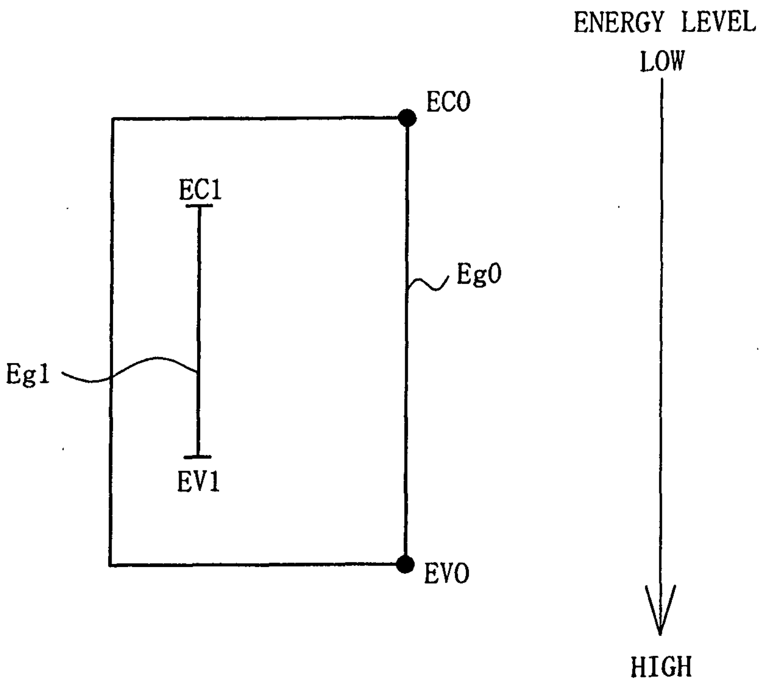
ENERGY LEVEL
LOW
EC0
EC1
Eg0
Eg1
EV1
EV0
HIGH

Fig. 6

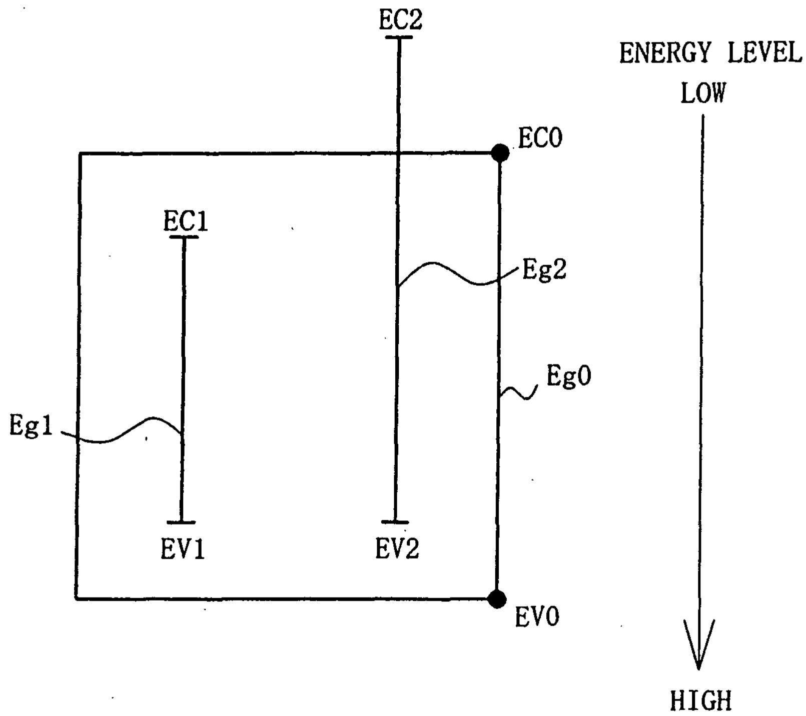
EC2
ENERGY LEVEL
LOW
EC0
EC1
Eg2
Eg0
Eg1
EV1
EV2
EV0
HIGH

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 63264692 A
- WO 946157 A
- JP 8048656 A
- JP 2000164362 A
- JP 2002038140 A
- JP 2002117980 A
- US 3112197 A
- US 3189447 A
- JP 3716096 B
- US 3615402 A
- US 3820989 A
- US 3542544 A
- JP 45555 B
- JP 51010983 B
- JP 51093224 A
- JP 55017105 A
- JP 56004148 A
- JP 55108667 A
- JP 55156953 A
- JP 56036656 A
- US 3180729 A
- US 4278746 A
- JP 55088064 A
- JP 55088065 A
- JP 49105537 A
- JP 55051086 A
- JP 56080051 A
- JP 56088141 A
- JP 57045545 A
- JP 54112637 A
- JP 55074546 A
- US 3615404 A
- JP 51010105 B
- JP 46003712 B
- JP 47025336 B
- JP 54053435 A
- JP 54110536 A
- JP 54119925 A
- US 3567450 A
- US 3180703 A
- US 3240597 A
- US 3658520 A
- US 4232103 A
- US 4175961 A
- US 4012376 A
- JP 49035702 B
- JP 3927577 B
- JP 55144250 A
- JP 56119132 A
- JP 56022437 A
- DE 1110518
- US 3526501 A
- US 3257203 A
- JP 56046234 A
- JP 54110837 A
- US 3717462 A
- JP 54059143 A
- JP 55052063 A
- JP 55052064 A
- JP 55046760 A
- JP 55085495 A
- JP 57011350 A
- JP 57148749 A
- JP 2311591 A
- JP 61210363 A
- JP 61228451 A
- JP 61014642 A
- JP 61072255 A
- JP 62047646 A
- JP 62036674 A
- JP 62010652 A
- JP 62030255 A
- JP 60093455 A
- JP 60094462 A
- JP 60174749 A
- JP 60175052 A
- US 4950950 A
- JP 2204996 A
- JP 2282263 A
- JP 1211399 A
- JP 632956965 A
- US 4127412 A
- JP 53027033 A
- JP 54058445 A
- JP 54149634 A
- JP 54064299 A
- JP 55079450 A
- JP 61295558 A
- JP 61098353 A
- JP 63295695 A
- US 5061569 A
- JP 4308688 A
- JP 8193191 A